(19) **Europäisches Patentamt / European Patent Office / Office européen des brevets**

(11) **EP 4 734 712 A1**

(12) # EUROPEAN PATENT APPLICATION

(43) Date of publication:
29.04.2026   Bulletin 2026/18

(21) Application number: 25194170.4

(22) Date of filing: 05.08.2025

(51) International Patent Classification (IPC):
*H10F 39/18* (2025.01)   *H10F 39/00* (2025.01)

(52) Cooperative Patent Classification (CPC):
H10F 39/8053; H10F 39/182; H10F 39/8063

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 24.10.2024 KR 20240147013

(71) Applicant: SAMSUNG ELECTRONICS CO., LTD.
Yeongtong-gu
Suwon-si, Gyeonggi-do 16677 (KR)

(72) Inventors:
• ROH, Sookyoung
16678 Suwon-si (KR)
• MUN, Sangeun
16678 Suwon-si (KR)
• NOH, Yohwan
16677 Suwon-si (KR)
• LEE, Jaeho
16677 Suwon-si (KR)

(74) Representative: Elkington and Fife LLP
Prospect House
8 Pembroke Road
Sevenoaks, Kent TN13 1XR (GB)

(54) **IMAGE SENSOR AND ELECTRONIC DEVICE INCLUDING THE IMAGE SENSOR**

(57)    An image sensor includes a sensor substrate including a first pixel group including a plurality of consecutively arranged first pixels, a second pixel group including a plurality of consecutively arranged second pixels, a third pixel group including a plurality of consecutively arranged third pixels, and a fourth pixel group including a plurality of consecutively arranged fourth pixels, and a nano-optical lens array including a first pixel-corresponding region facing the first pixel group, a second pixel-corresponding region facing the second pixel group, a third pixel-corresponding region facing the third pixel group, and a fourth pixel-corresponding region facing the fourth pixel group. The nano-optical lens array includes a plurality of nanoposts, and separates incident light according to wavelengths, multi-focuses green light on the plurality of first pixels and the plurality of fourth pixels, single-focuses blue light on the second pixel group, and single-focuses red light on the third pixel group.

FIG.  3A

**Description**

FIELD OF THE INVENTION

The disclosure relates to an image sensor and an electronic device including the image sensor.

BACKGROUND OF THE INVENTION

Image sensors detect a color of incident light by using a color filter. However, the color filter absorbs lights of colors other than a color corresponding to the color filter, and thus, the light utilization efficiency of the color filter may deteriorate. For example, in the case of RGB color filters, only one-third of incident light is transmitted and two-thirds of the incident light are absorbed, and thus, the light utilization efficiency of such color filter is only about 33 %. Accordingly, in color display apparatuses or color image sensors, most light loss occurs in color filters.

Accordingly, a structure that separates colors by using nanoposts has been employed in image sensors, and various attempts have been made to improve the color separation performance.

SUMMARY OF THE INVENTION

Provided are an image sensor including a nano-optical lens array with improved light efficiency and an electronic device including the image sensor.

Additional aspects will be set forth in part in the description which follows and, in part, will be apparent from the description, or may be learned by practice of the presented embodiments of the disclosure.

According to an aspect of the disclosure, there is provided an image sensor including: a sensor substrate including a first pixel group, a second pixel group, a third pixel group and a fourth pixel group, the first pixel group including a plurality of consecutively arranged first pixels, the second pixel group including a plurality of consecutively arranged second pixels, the third pixel group including a plurality of consecutively arranged third pixels, and the fourth pixel group including a plurality of consecutively arranged fourth pixels; and a nano-optical lens array including a first pixel-corresponding region facing the first pixel group, a second pixel-corresponding region facing the second pixel group, a third pixel-corresponding region facing the third pixel group, and a fourth pixel-corresponding region facing the fourth pixel group, wherein each of the first pixel-corresponding region, the second pixel-corresponding region, the third pixel-corresponding region, and the fourth pixel-corresponding region includes one or more nanoposts configured to separate incident light according to wavelengths, wherein the nano-optical lens array is configured to multi-focus green light respectively on the plurality of consecutively arranged first pixels or the plurality of consecutively arranged fourth pixels, single-focus blue light on the second pixel group, and single-focus red light on the third pixel group.

A first focal length of the nano-optical lens array with respect to the blue light may be 80 % or more and 120 % or less of a second focal length of the nano-optical lens array with respect to the green light.

The one or more nanoposts of the first pixel-corresponding region may be arranged to have 4-fold symmetry within a first region including a center of the first pixel-corresponding region with respect to the center.

An area of the first region may be 1/4 of an entire area of the first pixel-corresponding region.

The one or more nanoposts of the first pixel-corresponding region may be arranged to have 2-fold symmetry with respect to the center of the first pixel-corresponding region.

A distance indicating a phase difference $\pi$ in a blue light phase profile viewed in a cross-section immediately after passing through the second pixel-corresponding region may be greater than p and less than 1.25p in a case in which one width of the second pixel-corresponding region is 2p.

A distance indicating a phase difference $\pi$ in a red light phase profile viewed in a cross-section immediately after passing through the third pixel-corresponding region may be less than 1.25p in a case in which one width of the third pixel-corresponding region is 2p.

A nanopost having a largest size among the one or more nanoposts of the first pixel-corresponding region may be aligned with a center of the plurality of consecutively arranged first pixels facing the first pixel-corresponding region.

A nanoposts having a largest size among the one or more nanoposts of the first pixel-corresponding region may be shifted by a first distance in a direction toward a center of the first pixel-corresponding region compared to a center of the plurality of consecutively arranged first pixels facing the first pixel-corresponding region.

A first distance between centers of closest nanoposts in the first pixel-corresponding region may be a first period, a second distance between centers of closest nanoposts in the second pixel-corresponding region may be a second period, a third distance between centers of closest nanoposts in the third pixel-corresponding region may be a third period, and the first period and the second period may be different from each other.

The first period may be less than the second period.

The second period may be same as the third period.

A nanopost having a largest size among the one or more nanoposts of the second pixel-corresponding region may be aligned with a center of the plurality of consecutively arranged second pixels facing the second pixel-corresponding region.

A nanopost having a largest size among the one or more nanoposts of the third pixel-corresponding region may be aligned with a center of the third pixel group facing the third pixel-corresponding region.

A nanopost having a largest size among the one or more nanoposts in the first pixel-corresponding region, the second pixel-corresponding region, the third pixel-corresponding region and the fourth pixel-corresponding region, may be located in the third pixel-corresponding region.

A number of nanoposts in the first pixel-corresponding region may be greater than a number of nanoposts in the second pixel-corresponding region.

The sensor substrate may further include: a plurality of first pixel groups, a plurality of second pixel groups, a plurality of third pixel groups, and a plurality of fourth pixel groups, and wherein the nano-optical lens array may further include: an auxiliary structure region in which a plurality of nanoposts are arranged to: separate the incident light according to the wavelengths, single-focus part of the green light on one of the plurality of first pixel groups, single-focus remaining part of the green light on one of the plurality of fourth pixel groups, single-focus the blue light on one of the plurality of second pixel groups, and single-focus the red light on one of the plurality of third pixel groups.

The sensor substrate may further include: a plurality of first pixel groups, a plurality of second pixel groups, a plurality of third pixel groups, and a plurality of fourth pixel groups, and wherein the nano-optical lens array further includes an auxiliary structure region in which a plurality of nanoposts are arranged to: separate the incident light according to the wavelengths, single-focus part of the green light on one of the plurality of first pixel groups, multi-focus remaining part of the green light on a plurality of consecutively arranged fourth pixels of the plurality of fourth pixel groups, single-focus the blue light on one of the plurality of second pixel groups, and single-focus the red light on one of the plurality of third pixel groups.

The image sensor may further include: a color filter array provided between the sensor substrate and the nano-optical lens array.

According to another aspect of the disclosure, there is provided an electronic device including: a lens assembly configured to form an optical image of a subject; an image sensor configured to convert the optical image formed by the lens assembly into an electrical signal; and a processor configured to process a signal obtained by the image sensor, wherein the image sensor may include: a sensor substrate including a first pixel group, a second pixel group, a third pixel group and a fourth pixel group, the first pixel group including a plurality of consecutively arranged first pixels, the second pixel group including a plurality of consecutively arranged second pixels, the third pixel group including a plurality of consecutively arranged third pixels, and the fourth pixel group including a plurality of consecutively arranged fourth pixels; and a nano-optical lens array including a first pixel-corresponding region facing the first pixel group, a second pixel-corresponding region facing the second pixel group, a third pixel-corresponding region facing the third pixel group, and a fourth pixel-corresponding region facing the fourth pixel group, wherein each of the first pixel-corresponding region, the second pixel-corresponding region, the third pixel-corresponding region, and the fourth pixel-corresponding region includes one or more nanoposts configured to separate incident light according to wavelengths, wherein the nano-optical lens array is configured to multi-focus green light respectively on the plurality of consecutively arranged first pixels or the plurality of consecutively arranged fourth pixels, single-focus blue light on the second pixel group, and single-focus red light on the third pixel group.

BRIEF DESCRIPTION OF DRAWINGS

The above and other aspects, features, and advantages of certain embodiments of the disclosure will be more apparent from the following description taken in conjunction with the accompanying drawings, in which:

FIG. 1 is a schematic block diagram of an image sensor according to an embodiment;

FIG. 2A is a plan view illustrating a color arrangement of a pixel array of the image sensor according to an embodiment, FIG. 2B is a plan view illustrating a sensor substrate provided in the pixel array according to an embodiment, FIG. 2C is a plan view illustrating a nano-optical lens array provided in the pixel array according to an embodiment, and FIG. 2D is a plan view illustrating a color filter array provided in the pixel array according to an embodiment;

FIGS. 3A and 3B are cross-sectional views illustrating the pixel array of the image sensor according to an embodiment;

FIG. 4 is a plan view conceptually illustrating a size of a condensing lens corresponding to a plurality of regions of a nano-optical lens array provided in the pixel array of the image sensor according to an embodiment;

FIG. 5A shows phase profiles at positions immediately after blue light pass through a nano-optical microlens, FIG. 5B shows phase profiles at positions immediately after green light passes through a nano-optical microlens, and FIG. 5C shows phase profiles at positions immediately after red light passes through a nano-optical microlens;

FIG. 6 is a plan view illustrating a nanopost arrangement form of the nano-optical lens array provided in the pixel array of the image sensor according to an embodiment;

FIG. 7 is a plan view illustrating a nanopost arrangement form of a nano-optical lens array provided in the pixel array of the image sensor according to another embodiment;

FIG. 8 is a plan view illustrating a conceptual structure of a nano-optical lens array provided in the pixel array of the image sensor according to another embodiment;

FIG. 9 is a plan view illustrating a conceptual structure of a nano-optical lens array provided in the pixel array of the image sensor according to another embodiment;

FIG. 10 is a cross-sectional view of a pixel array of an image sensor according to another embodiment;

FIG. 11 is a schematic block diagram illustrating an example of an electronic device including an image sensor according to an embodiment;

FIG. 12 is a schematic block diagram illustrating a camera module included in the electronic device of FIG. 11;

FIG. 13 is a block diagram of an electronic device including a multi-camera module; and

FIG. 14 is a detailed block diagram of one camera module included in the electronic device shown in FIG. 13.

## DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The embodiments will be described in detail below with reference to accompanying drawings. The embodiments described herein are provided merely as an example, and may be embodied in many different forms. In the drawings, like reference numerals denote like components, and sizes of components in the drawings may be exaggerated for convenience of explanation.

Hereinafter, it will be understood that when a component is referred to as being "above" or "on" another component, the component may be directly on the other component or over the other component in a non-contact manner.

It will be understood that although the terms "first," "second," etc. may be used herein to describe various components, these components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprises" another component, the portion may not exclude another component but may further comprise another component unless the context states otherwise.

Also, the terms "... unit" and "... module" used herein specify a unit for processing at least one function or operation, and this may be implemented with hardware or software or a combination of hardware and software.

The use of the terms "a", "an", and "the" and similar referents are to be construed to cover both the singular and the plural.

Also, the steps of all methods described herein may be performed in any suitable order unless otherwise indicated herein or otherwise clearly contradicted by context. Also, the use of all exemplary terms (for example, etc.) provided herein, are intended merely to better illuminate the technical ideas and does not pose a limitation on the scope of rights unless otherwise claimed.

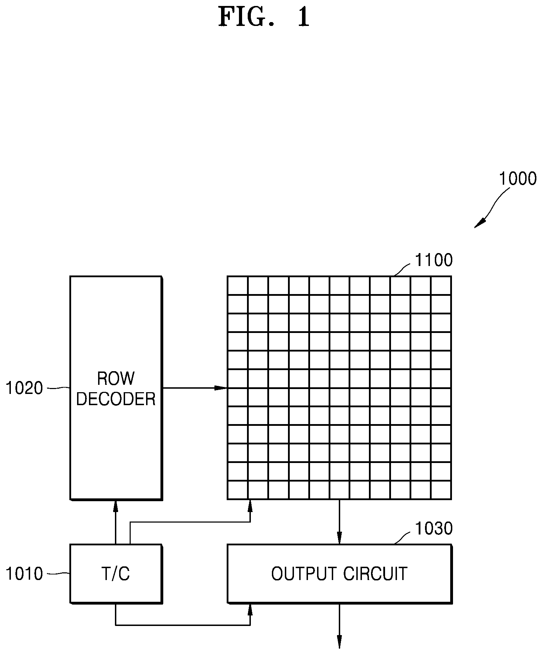

FIG. 1 is a schematic block diagram of an image sensor 1000 according to an embodiment. Referring to FIG. 1, the image sensor 1000 may include a pixel array 1100, a timing controller (T/C) 1010, a row decoder 1020, and an output circuit 1030. However, the disclosure is not limited thereto, and as such, according to an embodiment, the image sensor 1000 may include one or more other components. The image sensor 1000 may include, but is not limited to, a charge-coupled device (CCD) image sensor or a complementary metal oxide semiconductor (CMOS) image sensor.

The pixel array 1100 includes pixels that are two-dimensionally arranged along a plurality of rows and columns. The row decoder 1020 selects one of the rows of the pixel array 1100 based on a row address signal output from the timing controller 1010. For example, the row decoder 1020 selects one of the rows of the pixel array 1100 in response to a row address signal output from the timing controller 1010. The output circuit 1030 outputs a photosensitive signal, in a column unit, from a plurality of pixels arranged along the selected row. For example, the output circuit 1030 may include a column decoder and an analog-to-digital converter (ADC). For example, the output circuit 1030 may include a plurality of ADCs arranged for each column between the column decoder and the pixel array 1100 or a single ADC arranged at an output end of the column decoder. The timing controller 1010, the row decoder 1020, and the output circuit 1030 may be implemented by using a single chip or separate chips. A processor for processing an image signal output through the output circuit 1030 may be implemented by using a single chip together with the timing controller 1010, the row decoder 1020, and the output circuit 1030.

The pixel array 1100 may include the plurality of pixels that detect light of different wavelength bands. An arrangement of the plurality of pixels may be implemented in various ways.

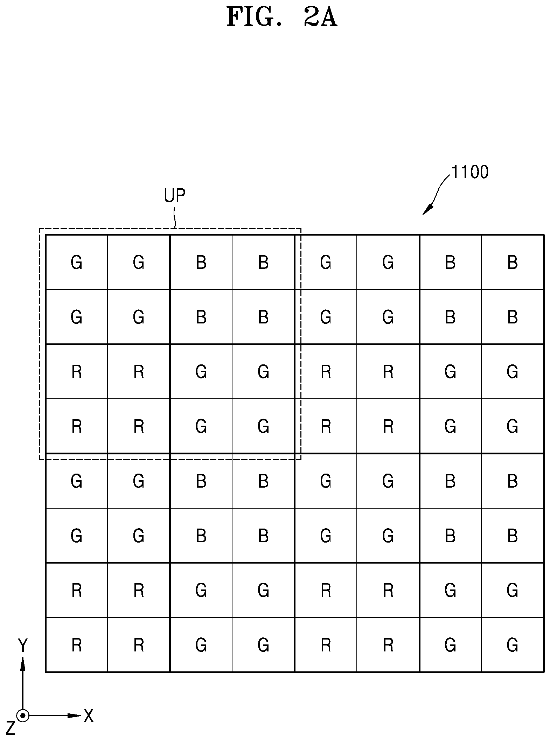

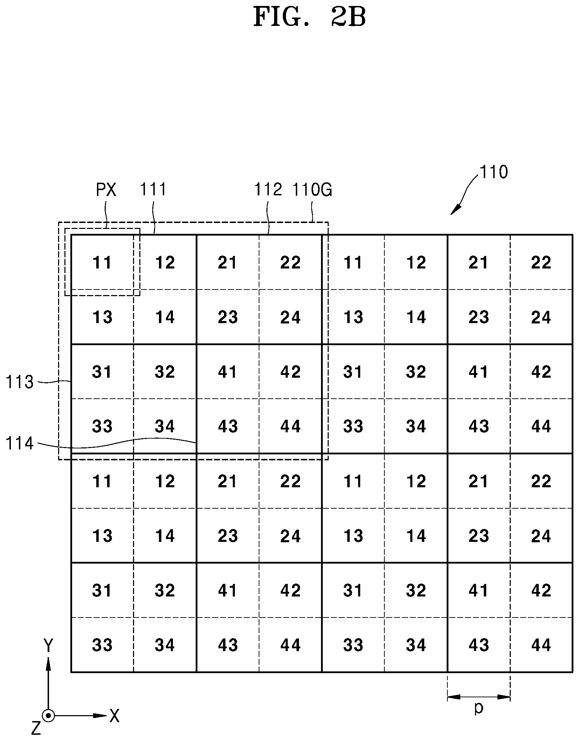

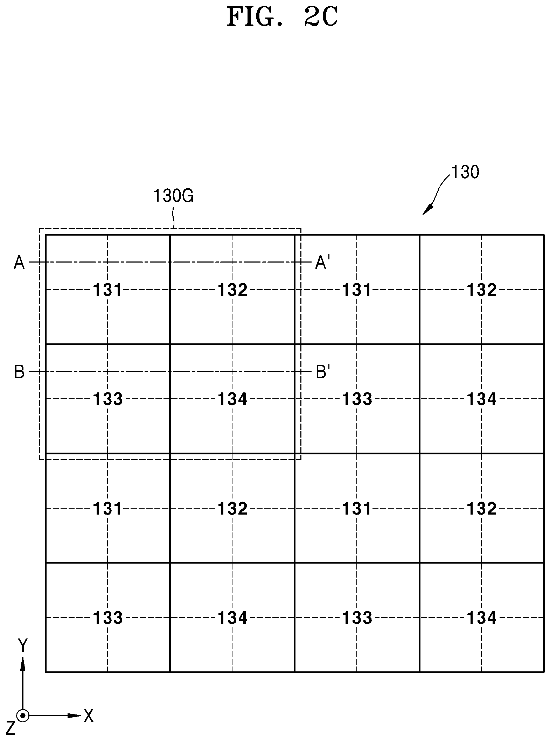

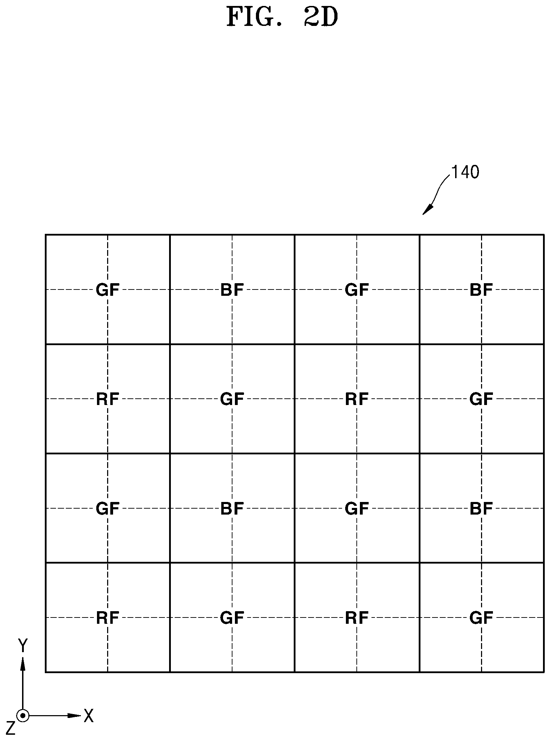

FIG. 2A is a plan view illustrating a color arrangement of the pixel array 1100 of the image sensor 1000 according to an embodiment, FIG. 2B is a plan view illustrating a sensor substrate 110 provided in the pixel array 1100 according to an embodiment, FIG. 2C is a plan view illustrating a nano-optical lens array 130 provided in the pixel array 1100 according to an embodiment, and FIG. 2D is a plan view illustrating a color filter array 140 provided in the pixel array 1100 according to an embodiment.

According to an embodiment, the pixel array 1100 of the image sensor 1000 may include a color arrangement as illustrated shown in FIG. 2A. For example, the color arrangement illustrated in FIG. 2A is similar to a Bayer pattern, but is different from a general Bayer pattern in that the same color appears adjacent in a 2×2 arrangement. For example, a 2×2 arrangement of green (G) color, a 2×2 arrangement of blue (B) color, a 2×2 arrangement of red (R) color, and a 2×2 arrangement of green (G) color form a unit pattern (UP), and these unit patterns (UP) are repeatedly arranged two-dimensionally in a first direction (X direction) and a second direction (Y direction). According to an embodiment, the color arrangement as illustrated in FIG. 2A may be used to improve sensitivity in micro image sensors.

The color arrangement of FIG. 2A is an example, and the disclosure is not limited thereto. For example, a CYGM arrangement in which magenta (M), cyan (C), yellow (Y), and green (G) are represented in one unit pattern, or an RGBW arrangement in which green, red, blue, and white are represented in one unit pattern may be used. In addition, the unit pattern (UP) may be implemented in the form of a 3x2 array, and the pixels in the pixel array 1100 may be arranged in various ways according to color characteristics of the image sensor 1000. The color arrangement based on red (R), green (G), and blue (B) will be described below, but a color arrangement of a different type may be applied.

Referring to FIGS. 2B and 2C, the pixel array 1100 of the image sensor 1000 may include a sensor substrate 110 having a pixel arrangement corresponding to such a color arrangement, and a nano-optical lens array 130 that enables incident light to be divided according to wavelengths and condenses corresponding light of wavelengths onto the pixels. For example, FIGS. 2B and 2C are plan views respectively illustrating the sensor substrate 110 and the nano-optical lens array 130.

Referring to FIG. 2B, the sensor substrate 110 may include a plurality of pixels PX detecting incident light. For example, the plurality of pixels PX may generate an image signal by converting incident light into an electrical signal. For example, each of the plurality of pixels PX may be configured to generate an electronic signal by converting incident light on the respective pixel into the electrical signal. The sensor substrate 110 may include a plurality of unit pixel groups 110G. The unit pixel group 110G corresponds to the unit pattern (UP) shown in FIG. 2A one-to-one. The unit pixel group 110G includes a first pixel group 111, a second pixel group 112, a third pixel group 113, and a fourth pixel group 114. The first pixel group 111, the second pixel group 112, the third pixel group 113, and the fourth pixel group 114 are arranged 2x2 in the first direction (X direction) and the second direction (Y direction). The first pixel group 111 includes four first pixels (11, 12, 13, and 14) arranged in 2×2 arrangement, the second pixel group 112 includes four second pixels (21, 22, 23, and 24) arranged in 2×2 arrangement, the third pixel group 113 includes four third pixels (31, 32, 33, and 34) arranged in 2×2 arrangement, and the fourth pixel group 114 includes four fourth pixels (41, 42, 43, and 44) arranged in 2×2 arrangement. For example, the first pixel group 111 may include a first first pixel 11, a second first pixel 12, a third first pixel 13, and a fourth first pixel 14. The second pixel group 112 may include a first second pixel 21, a second second pixel 22, a third second pixel 23, and a fourth second pixel 24. The third pixel group 113 may include a first third pixel 31, a second third pixel 32, a third third pixel 33, and a fourth third pixel 34. The fourth pixel group 114 may include a first fourth pixel 41, a second fourth pixel 42, a third fourth pixel 43, and a fourth fourth pixel 44. However, the disclosure is not limited thererto. As such, the number of pixels in each group may be different than four and/or the arrangement of the pixels in each group may be different than the 2x2 arrangement.

The pixel arrangement of the sensor substrate 110 is for sensing the incident light by dividing the incident light into colors of the arrangement as shown in FIG. 2A. The first pixel group 111 and the fourth pixel group 114 may correspond to green light, the second pixel group 112 may correspond to blue light, and the third pixel group 113 may correspond to red light. Hereinafter, a first pixel group may be used interchangeably as a first green pixel group, a second pixel group as a blue pixel group, a third pixel group as a red pixel group, and a fourth pixel group as a second green pixel group. In addition, a first pixel may be used interchangeably as a first green pixel, a second pixel as a blue pixel, a third pixel as a red pixel, and a fourth pixel as a second green pixel.

Each of the pixels PX may independently include a photosensitive cell for sensing incident light. Individual pixels, that is, the four first pixels 11, 12, 13, and 14 of the first pixel group 111, the four second pixels 21, 22, 23, and 24 of the second pixel group 112, the four third pixels 31, 32, 33, and 34 of the third pixel group 113, and the four fourth pixels 41, 42, 43, and 44 of the fourth pixel group 114, may be used as independent image pixels. Some of the four first pixels 11, 12, 13, and 14 of the first pixel group 111, the four second pixels 21, 22, 23, and 24 of the second pixel group 112, the four third pixels 31, 32, 33, and 34 of the third pixel group 113, and the four fourth pixels 41, 42, 43, and 44 of the first pixel group 114 may be used as auto-focus pixels. Some pixels may be used only for auto-focus signal generation and may not be used as independent image pixels. However, this is an example, the disclosure is not limited thereto, and each of the plurality of pixels may be used for image signal generation and auto-focus signal generation.

The auto-focus signal may be obtained from a difference between output signals of adjacent auto-focus pixels. In an example case in which the four second pixels 21, 22, 23, and 24 of the second pixel group 112 are used as auto-focus pixels, the auto-focus signal may be generated from a difference between the sum of output signals of the two second pixels 21 and 23 on the left and output signals of the two second pixels 22 and 24 on the right.

The adjacent pixels PX may be electrically separated from each other by an isolation structure. Although FIG. 2B simply illustrates a boundary between adjacent pixels PX as a line, the isolation structure may have a physical thickness. The isolation structure may be formed as, for example, a deep trench isolation (DTI) structure. A deep trench may be filled with air or an electrically insulating material. A plurality of electrically separated cells may be formed by forming a light sensing layer, and then forming the DTI structure on the light sensing layer. One pixel PX may be divided into two or more photosensitive cells.

A width of the pixel PX in a first direction is denoted by p, and in FIG. 2B, p is indicated to be equal to a pixel pitch defined as a distance between centers of adjacent pixels PX. However, due to the thickness of the isolation structure, the pixel width may be less than the pixel pitch.

Referring to FIG. 2C, the nano-optical lens array 130 includes a plurality of pixel-corresponding regions. According to an embodiment, each of the plurality of pixel-corresponding regions of the nano-optical lens array 130 may be provided with nanoposts. The region division of the nano-optical lens array 130 and the shapes and arrangement of the nanoposts provided in each of the plurality of pixel-corresponding regions may be set to form a phase profile that enables incident light to be divided according to wavelengths and be condensed on facing pixels. In the following description, color separation in a visible light band will be explained. However, the disclosure is not limited thereto, and a wavelength band may be expanded to the range of visible light to infrared light, or to any of various other ranges.

The nano-optical lens array 130 includes a plurality of pixel corresponding groups 130G corresponding to the plurality of unit pixel groups 110G of the sensor substrate 110 shown in FIG. 2B, respectively. The pixel corresponding group 130G includes a first pixel-corresponding region 131 facing the first pixel group 111, a second pixel-corresponding region 132 facing the second pixel group 112, a third pixel-corresponding region 133 facing the third pixel group 113, and a fourth pixel-corresponding region 134 facing the fourth pixel group 114. The first to fourth pixel-corresponding regions 131, 132, 133, and 134 may be used interchangeably as a first green pixel-corresponding region, a blue pixel-corresponding region, a red pixel-corresponding region, and a second green pixel-corresponding region, respectively.

According to the shape and arrangement of a plurality of nanoposts provided in each of the first to fourth pixel-corresponding regions 131, 132, 133, and 134, incident light may be separated according to wavelengths and condensed onto pixels provided on the sensor substrate 110. Different light condensing patterns may be formed for each color by the nano-optical lens array 130. For example, light of a first color may be multi-focused on each of a plurality of adjacent pixels that represent the first color, and light of a second color may be single-focused to the center of the plurality of adjacent pixels that represent the second color. According an embodiment, the term multi-focused may refer to condensing light of a first color towards a center of each of the plurality of adjacent pixels that represent the first color. For example, the first color light may be separated into four portions and each of the four portions are condensed towards a respective one of centers of the plurality of adjacent pixels. According an embodiment, the term single-focused may refer to condensing light of a second color towards a center of the plurality of adjacent pixels that represent the second color. In the single-focused condensing of the light, the second light may not be separated into multiple portions. For example, the nano-optical lens array 130 may multi-focus the green light on each of the plurality of first pixels 11, 12, 13, and 14, and the plurality of fourth pixels 41, 42, 43, and 44, single-focus the blue light on the second pixel group 112, and single-focus the red light on the third pixel group 113.

Referring to FIG. 2D, a color filter array 140 may be further provided. The color filter array 140 includes a green filter GF, a blue filter BF, a red filter RF, and a green filter GF respectively facing the first pixel-corresponding region 131, the second pixel-corresponding region 132, the third pixel-corresponding region 133, and the fourth pixel-corresponding region 134 shown in FIG. 2C. The color filter array 140 may be provided to increase color purity. The color filter array 140 may be omitted.

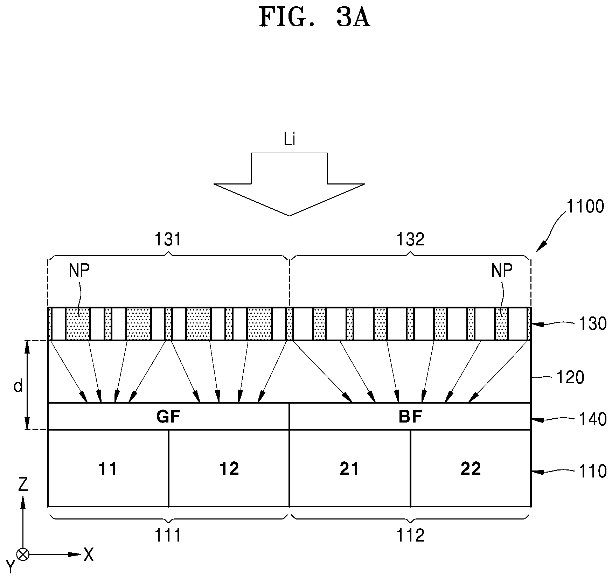

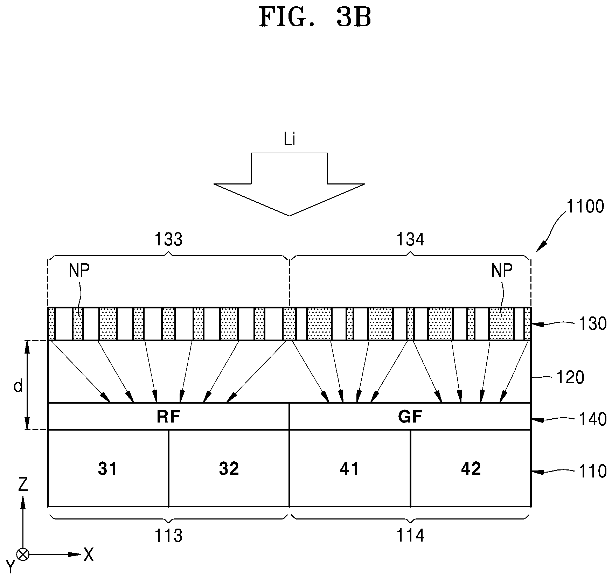

FIGS. 3A and 3B are cross-sectional views showing the pixel array 1100 of the image sensor 1000 according to an embodiment.

FIG. 3A is a cross-sectional view taken along the line A-A' in FIG. 2C, and FIG. 3B is a cross-sectional view taken along the line B-B' in FIG. 2C.

Referring to FIGS. 3A and 3B, the pixel array 1100 of the image sensor 1000 includes the sensor substrate 110 and the nano-optical lens array 130 provided on the sensor substrate 110. The color filter array 140 may be provided between the sensor substrate 110 and the nano-optical lens array 130.

The sensor substrate 110 may include the first pixel group 111, the second pixel group 112, the third pixel group 113, and the fourth pixel group 114, as described with reference to FIG. 2B, and the first pixel group 111 may include the four first pixels 11, 12, 13, and 14, the second pixel group 112 may include the four second pixels 21, 22, 23, and 24, the third pixel group 113 may include the four third pixels 31, 32, 33, and 34, and the fourth pixel group 114 may include the four fourth pixels 41, 42, 43, and 44.

The nano-optical lens array 130 may include the first to fourth pixel-corresponding regions 131, 132, 133, and 134. The nano-optical lens array 130 may include the plurality of nanoposts NP, and the plurality of nanoposts NP may be arranged in the first to fourth pixel-corresponding regions 131, 132, 133, and 134. Each of the first to fourth pixel-corresponding regions 131, 132, 133, and 134 may include at least one nanopost NP.

According to the shape and arrangement of the nanoposts NP, incident light may be separated according to wavelengths and condensed on the first to fourth pixel groups 111, 112, 113, and 114. For example, green light may be multi-focused on the four first pixels 11, 12, 13, and 14 of the first pixel group 111, and the four fourth pixels 41, 42, 43, and 44 of the fourth pixel group 114, blue light may be single-focused on the second pixel group 112, and red light may be single-focused on the third pixel group 113. For example, among a light Li incident on the one pixel corresponding group 130G as defined in FIG. 2C, part of the green light may be multi-focused on the four first pixels 11, 12, 13, and 14, the remaining part of the green light may be multi-focused on the four fourth pixels 41, 42, 43, and 44, the blue light may be single-focused on the second pixel group 112, and the red light may be single-focused on the third pixel group 113.

For examples, the arrangement of the nanoposts NP in the first to fourth pixel-corresponding regions 131, 132, 133, and 134 may be set such that a phase profile suitable for such a condensing profile is formed at a position immediately after the incident light passes through the nano-optical lens array 130.

According to an embodiment, the refractive index of a material varies according to the wavelength of light that reacts, and therefore the nano-optical lens array 130 may provide different phase profiles for light of different wavelengths. For example, because a refractive index of even the same material varies according to the wavelength of light reacting with the material and a phase delay experienced by light when the light has passed through the material also varies according to the wavelength, different phase profiles may be formed for different wavelengths. For example, because a refractive index of the first pixel-corresponding region 131 with respect to first wavelength light may be different from a refractive index of the first pixel-corresponding region 131 with respect to second wavelength light, and a phase delay experienced by the first wavelength light that has passed through the first pixel-corresponding region 131 may be different from a phase delay experienced by the second wavelength light that has passed through the first pixel-corresponding region 131, in an example case in which the nano-optical lens array 130 is designed by taking these characteristics of light into consideration, different phase profiles may be provided to lights of different colors.

The plurality of nanoposts NP included in the nano-optical lens array 130 may be arranged according to a specific rule to form different phase profiles for lights of a plurality of wavelengths. Here, the rule is applied to parameters such as the shapes, sizes (widths and heights), spacing, and arrangement form of the nanoposts NP, and these parameters may be determined according to a phase profile for each color to be implemented through the nano-optical lens array 130.

The nanopost NP may have a geometric dimension of a subwavelength. Here, the sub-wavelength refers to a wavelength smaller than the wavelength band of light that is to be branched. The nanopost NP may have a cylindrical shape having a cross-section diameter of a sub-wavelength. However, the shape of the nanopost NP is not limited thereto, and may be in the shape of an elliptical pillar or polygonal pillar. The nanoposts NP may be posts having other, symmetrical, or asymmetric cross-sectional shapes. The nanoposts NP are each shown as having constant widths perpendicular to a height direction (Z direction), that is, are shown in a rectangular shape having a cross-section parallel to the height direction, but this is an example. Unlike what is shown in FIGS. 3A and 3B, the nanoposts NP may have constant widths perpendicular to the height direction, and, for example, the shape of a cross-section parallel to the height direction may be a trapezoid or an inverted trapezoid. In an example case in which incident light is visible light, the diameter of the cross-section of the nanopost NP may have a dimension smaller than, for example, 400 nm, 300 nm, or 200 nm. Meanwhile, the height of the nanopost NP may be 500 nm to 1500 nm, and may be greater than the diameter of the cross-section of the nanopost NP. According to an embodiment, the nanopost NP may be a combination of two or more posts stacked in the height direction (Z direction). The height of the nanoposts NP may range from a sub-wavelength to several times a wavelength. For example, the height of the nanoposts NP may be 5 times or less, 4 times or less, or 3 times or less of the center wavelength of a wavelength band in which the nano-optical lens array 130 branches. The nanoposts NP are all shown as having the same height, but the disclosure is not limited thereto. Details of the nanopost NP may be determined by considering detailed process conditions, along with a phase profile for color separation.

A space between nanoposts NP may be filled with a peripheral material having a different refractive index from the nanoposts NP. The nanopost NP may include a material having a different refractive index from the peripheral material. For example, the nanopost NP may include, but is not limited to, c-Si, p-Si, a-Si, III-V compound semiconductors (GaP, GaN, GaAs, etc.), SiC, TiO2, SiN, and/or a combination thereof. The nanopost NP with a difference in refractive index from a peripheral material may change a phase of light that transmitted through the nanopost NP. This is due to a phase delay caused by the shape dimension of a sub-wavelength of the nanopost NP, and a degree of phase delay is determined by a detailed shape dimension and an arrangement form of the nanopost NP. The peripheral material of the nanopost NP may include a dielectric material having a lower refractive index than the nanopost NP. For example, the peripheral material may include $SiO_2$ or air. However, this is an example, and the materials of the nanoposts NP and the peripheral material may be set such that the nanopost NP has a lower refractive index than the peripheral material.

According to an embodiment, a spacer layer 120 may be provided between the semiconductor substrate 110 and the nano-optical lens array 130. The spacer layer 120 may be a transparent spacer layer. The spacer layer 120 may support the nano-optical lens array 130, and may have a distance between the sensor substrate 110 and the nano-optical lens array 130. For example, the spacer layer 120 may have a thickness that satisfies requirements of a distance d between the upper surface of the sensor substrate 110 and the lower surface of the nano-optical lens array 130.

The spacer layer 120 may include a material that is transparent to visible light. For example, the spacer layer 120 may include a dielectric material having a lower refractive index than the nanoposts NP and a low absorption rate in a visible light band, such as $SiO_2$ or siloxane-based spin on glass (SOG). In an example case in which a peripheral material layer filled between the nanoposts NP includes a material having a higher refractive index than the nanopost NP, the spacer layer 120 may include a material having a lower refractive index than the peripheral material layer.

The distance d between the lower surface of the nano-optical lens array 130 and the upper surface of the sensor substrate 110 may be determined with respect to the focal length of light condensed by the nano-optical lens array 130. In an example case, the distance d between the lower surface of the nano-optical lens array 130 and the upper surface of the sensor substrate 110 may be 1/2 or less of the focal length of the green light. In another example case, the distance d may be approximately 70 % to 180 % of the pitch of the pixel PX. In addition, in the setting of the distance d between the lower surface of the nano-optical lens array 130 and the upper surface of the sensor substrate 110, the multi-focusing efficiency of green light to the first pixels 11, 12, 13, and 14 of the first pixel group 114, and the fourth pixels 41, 42, 43, and 44 of the first pixel group 114, the single-focusing efficiency of blue light to the second pixel group 112, and the single-focusing efficiency of red light to the third pixel group 113 as described above may be considered. In an example case in which the distance d is determined as above, a thickness of the spacer layer 120 may vary depending on the color filter array 140 between the sensor substrate 110 and the nano-optical lens array 130. The thickness of the spacer layer 120 may be determined in consideration of the determined distance d, the thickness and effective refractive index of the color filter array 140, and the effective refractive index of the spacer layer 120.

The shape and arrangement of the nanoposts NP of the nano-optical lens array 130 may be set such that the above-described light condensing pattern is implemented, and the focal lengths with respect to light of different wavelengths are the same. For example, a focal length f1 of the nano-optical lens array 130 with respect to the green light and a focal length f2 of the nano-optical lens array 130 with respect to the blue light may be the same or almost the same. For example, f2 may be in a range of 80 % or more and 120 % or less of f1. The focal length f1 of the nano-optical lens array 130 with respect to the green light and a focal length f3 of the nano-optical lens array 130 with respect to the red light may be the same or almost the same. For example, f3 may be in a range of 80 % or more and 120 % or less of f1.

A focal length f of a nano-optical lens with respect to a certain wavelength light may be expressed in the following schematic equation.

$$\frac{2\pi n}{\lambda} f + \varphi_{x_0} - \left( \frac{2\pi n}{\lambda} \sqrt{x^2 + f^2} + \varphi_x \right) = 2\pi, \ f = \text{focal length}$$

Here, x may be the size of the nano-optical lens.

In an example case in which the focal length f2 with respect to the blue light and the focal length f1 with respect to the green light are not separately adjusted, the focal lengths f2 and f1 have very different values. In an example case in which a nano-optical lens with the condition of $\varphi_x - \varphi_{x0} = \pi$ is formed on an upper portion of a Chroma Qcell with the pixel size of 0.64 $\mu$m to achieve the maximum sensitivity efficiency, a lens corresponding to the green light becomes a lens with a size twice of 0.64 $\mu$m (x=0.64um*2), and a lens corresponding to the blue light and the red light becomes a lens with a size 3 to 4 times of 0.64 $\mu$m (x=0.64um*3). Therefore, according to the above equation, the focal length f2 with respect to the blue light is about 6 $\mu$m, and the focal length f1 with respect to the green light is about 1 $\mu$m.

In an example case in which different color lights have very different focal lengths, a difference in condensing performance in an image sensor increases crosstalk and makes it difficult to detect a phase difference for auto-focus. Therefore, a target phase for each position may be adjusted so that focal length f1 with respect to color light (e.g., green light,) having a small lens size is obtained by adjusting a phase gradient according to an individual color. The phase profile may be adjusted such that a deviation of the focal length f2 with respect to the blue light or the focal length f3 with respect to the red light of the nano-optical lens array 130 is within a range of -20 % to +20 % with respect to the focal length f1 with respect to the green light.

According to an embodiment, an etch stop layer may be provided between the spacer layer 120 and the nano-optical lens array 130. For example, the etch stop layer may be provided to protect the spacer layer 120, which is a lower structure of the nano-optical lens array 130, in a manufacturing process of the nano-optical lens array 130. In an example case in which the nano-optical lens array 130 is manufactured on the spacer layer 120, a process of generally depositing a dielectric layer to be formed as the peripheral material between the nanoposts NP on the spacer layer 120, and etching the dielectric layer to a certain depth is performed. At this time, the spacer layer 120 may be damaged as the dielectric layer is etched to more than a desired depth, and when the thickness of the spacer layer 120 does not meet a requirement for a distance between the nano-optical lens array 130 and the sensor substrate 110, color separation performance may deteriorate. The etch stop layer may include a material with a lower etch selectivity than the dielectric layer to be etched, and as such, the etch stop layer is not easily removed during the etching process and remains Accordingly, damage to the spacer layer 120 from the etching process may be prevented. The etch stop layer may include, but is not limited to, $HfO_2$. A thickness of the etch stop layer may be determined by considering an etch depth, that is, the height of the nanopost NP, and may also be determined by considering an etch distribution within a process wafer. The etch stop layer may have a thickness of about 3nm to about 30nm.

According to an embodiment, a protective layer that protects the nano-optical lens array 130 may be further provided on the nano-optical lens array 130. The protective layer may include a material that serves as an anti-reflection layer. The anti-reflection layer may improve light utilization efficiency of the pixel array 1100 by reducing light reflected by the upper surface of the nano-optical lens array 130 among incident light. For example, the anti-reflection layer helps light incident from the outside onto the pixel array 1100 to be not reflected on the upper surface of the nano-optical lens array 130 and pass through the nano-optical lens array 130 and thus be detected by the sensor substrate 110. The anti-reflection layer may have a structure in which one or more layers are stacked, for example, a structure including one layer formed of a different material from the material used to form the nano-optical lens array 130 or including a plurality of material layers with different refractive indices.

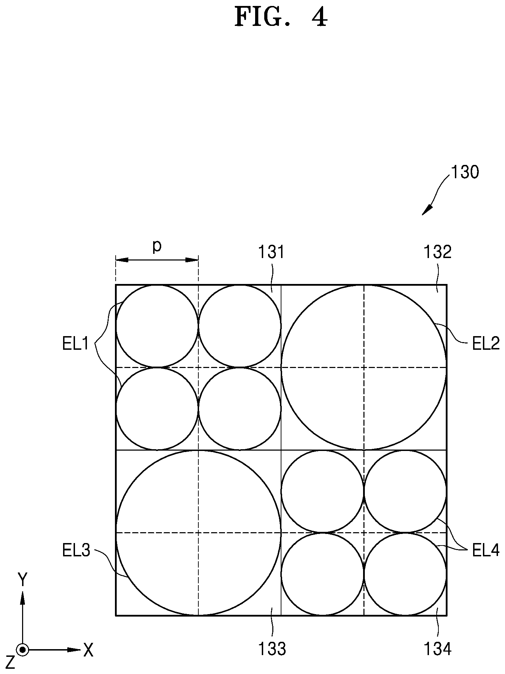

FIG. 4 is a plan view conceptually illustrating a size of a condensing lens corresponding to a plurality of regions of the nano-optical lens array 130 provided in the pixel array 1100 of the image sensor 1000 according to an embodiment.

The condensing pattern shown in FIGS. 3A and 3B may be explained as a concept in which effective condensing lenses of different sizes are formed for each color by the nano-optical lens array 130. For example, the nano-optical lens array 130 may be configured such that the first pixel-corresponding region 131 may effectively form four first lenses EL1, the second pixel-corresponding region 132 may form a second lens EL2, the third pixel-corresponding region 133 may form a third lens EL3, and the fourth pixel-corresponding region 134 may form four fourth lenses EL4. Each of the four first lenses EL1 may have an effective diameter of p and condense green light. The second lens EL2 may have an effective diameter of 2p and condense blue light. The third lens EL3 having the effective diameter of 2p and condense red light. Each of the four fourth lenses EL4 may have the effective diameter of p and condense green light.

In FIG. 4, the first lenses EL1, the second lens EL2, the third lens EL3, and the fourth lenses EL4 illustrate conceptually that the nano-optical lens array 130 forms different condensing patterns with respect to light of different wavelengths, and the effective diameters of the first lenses EL1, the second lens EL2, the third lens EL3, and the fourth lenses EL4 are not limited to the shown sizes.

A structure including the sensor substrate 110 of the pixel array according to an embodiment and the nano-optical lens array 130 forming the above-described condensing pattern may be referred to as a Chroma-Qcell structure. For example, a structure in which a lens including the sensor substrate 110 with a same pixel arrangement as illustrated in FIG. 4 and having the effective diameter of p with respect to all colors is formed may be called a Tetra structure. The Tetra structure has an advantage in terms of resolution, but may be poor in generating the auto-focus signal. In addition, a structure in which a lens including the sensor substrate 110 with the same pixel arrangement as illustrated in FIG. 4 and having the effective diameter of 2p with respect to all colors is formed may be called a Qcell structure. The Qcell structure has an advantage in generating an auto-focus signal, but have degraded resolution.

However, the Chroma-Qcell structure illustrated according to embodiment in FIG. 4 may supplement problems related to generating the auto-focus signal in Tetra structure and/or problems related to resolution degradation in the Qcell structure.

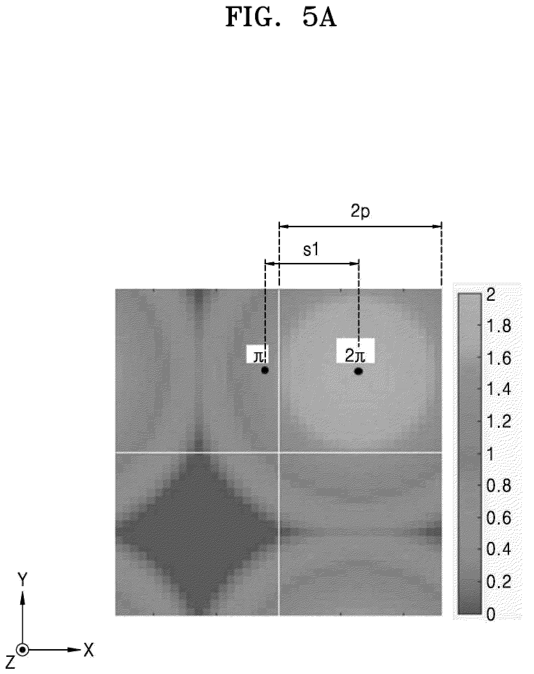

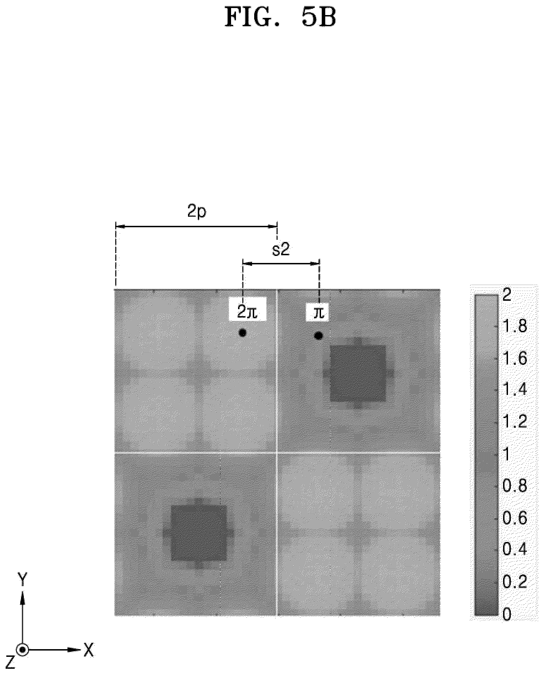

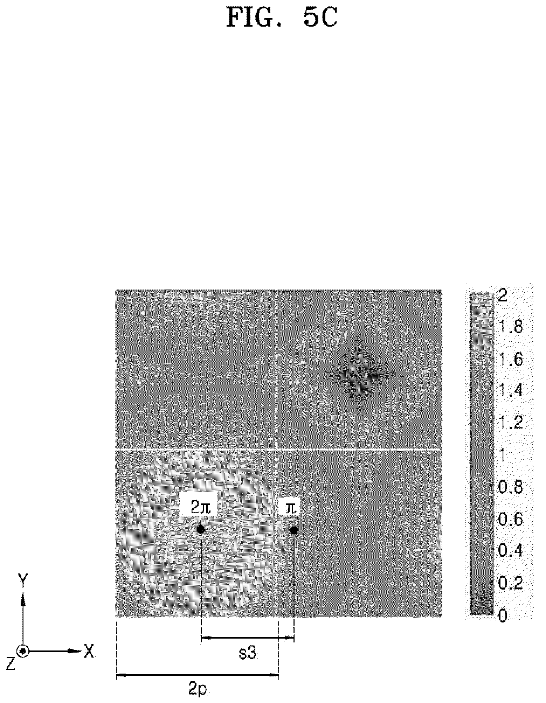

FIG. 5A shows phase profiles at positions immediately after blue light pass through the nano-optical lens array 130, FIG. 5B shows phase profiles at positions immediately after green light passes through the nano-optical lens array 130, and FIG. 5C shows phase profiles at positions immediately after red light passes through the nano-optical lens array 130.

Referring to FIG. 5A, in the shown cross-section, the blue light represents the maximum phase of $2\pi$ at a position facing the center of the second pixel-corresponding region 132. The farther from the position, the smaller the phase value, and a distance between the maximum phase position and a position indicating a phase difference $\pi$ from the maximum phase is indicated by s1. s1 may be greater than, for example, p. s1 may be greater than p, less than 1.5p, or less than 1.25p. Typically, such a phase difference distance in a Qcell structure is known to be almost p, and a blue light phase profile in the Chroma-Qcell structure according to an embodiment may be steeper than a blue light phase profile in the general Qcell structure.

Referring to FIG. 5B, in the shown cross-section, the green light represents the maximum phase $2\pi$ at four positions facing the center of each of the four first pixels 11, 12, 13, and 14 of the first pixel-corresponding region 131. The farther from the position, the smaller the phase value, in a direction away from the first pixel-corresponding region 131, and a distance between the maximum phase position and the position indicating the phase difference $\pi$ from the maximum phase is indicated by s2. For example, s2 may be greater than p/2, and may be approximately p.

Referring to FIG. 5C, in the shown cross-section, the red light represents the maximum phase $2\pi$ at a position facing the center of the third pixel-corresponding region 133. The farther from the position, the smaller the phase value, and a distance between the maximum phase position and the position indicating the phase difference $\pi$ from the maximum phase is indicated by s3. s3 may be greater than, for example, p. s3 may be greater than p, less than 1.5p, or less than 1.25p. Typically, such a phase difference distance in the Qcell structure is known to be almost p. A red light phase profile in the Chroma-Qcell structure according to an embodiment may be steeper than a red light phase profile in the general Qcell structure.

According to an embodiment, a phase profile as illustrated in FIGS. 5A-5C may be designed such that the nano-optical lens array 130 forms the condensing pattern as described with reference to FIG. 4 and, in detail, implements almost the same focal length with respect to the green light, the blue light, and the red light. In an example case in which p is 0.64 $\mu$m, a focal length of the nano-optical lens array 130 with respect to the green light may be 1 $\mu$m $\pm$ 400nm, the focal length of the nano-optical lens array 130 with respect to the blue light may be 1 $\mu$m $\pm$ 400nm, and the focal length of the nano-optical lens array with respect to the red light may be 1 $\mu$m $\pm$ 400nm.

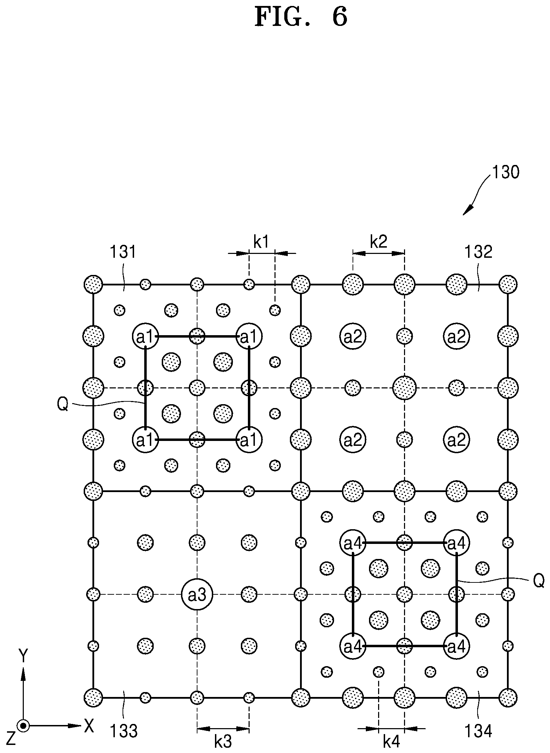

FIG. 6 is a plan view illustrating a nanopost arrangement form of the nano-optical lens array 130 provided in the pixel array 1100 of the image sensor 1000 according to an embodiment.

The nanoposts NP of the second pixel-corresponding region 132 and the third pixel-corresponding region 133 may be arranged to have 4-fold symmetry. The nanoposts NP of the second pixel-corresponding region 132 may have rotation symmetry of 90 degrees, 180 degrees, and 270 degrees with respect to the center of the second pixel-corresponding region 132. The nanoposts NP of the third pixel-corresponding region 133 may have rotation symmetry of 90 degrees, 180 degrees, and 270 degrees with respect to the center of the third pixel-corresponding region 133.

The nanoposts NP of the first pixel-corresponding region 131 and the fourth pixel-corresponding region 134 may be arranged to have 2-fold symmetry. The nanoposts NP of the first pixel-corresponding region 131 may have rotation symmetry of 180 degrees with respect to the center of the first pixel-corresponding region 131. The nanoposts NP of the fourth pixel-corresponding region 134 may have rotation symmetry of 180 degrees with respect to the center of the fourth pixel-corresponding region 134.

The nanoposts NP of the first pixel-corresponding region 131 may be arranged to have 4-fold symmetry in a partial region Q in the first pixel-corresponding region 131. The partial region Q may be a rectangular area as shown, and may be an area corresponding to 1/4 of the entire first pixel-corresponding region 131 including the center of the first pixel-corresponding region 131. The area corresponding to 1/4 of the entire first pixel-corresponding region 131 is an example and the area may be smaller than 1/4 of the entire first pixel-corresponding region 131. The shape or area of the partial region Q is an example and is not limited thereto. For example, in a region that is located in the center and has different shapes and different areas, the nanoposts NP may have 4-fold symmetry.

The nanoposts NP of the fourth pixel-corresponding region 134 may also be arranged to have symmetry similar to that of the first pixel-corresponding region 131. The arrangements of the nanoposts NP of the first pixel-corresponding region 131 and the nanopost NP of the fourth pixel-corresponding region 134 may be rotated by 90 degrees to each other.

The nanoposts NP having the largest size among the nanoposts NP of the first pixel-corresponding region 131 are indicated by a1, and may be provided at positions aligned with the center of the four first pixels 11, 12, 13, and 14 facing each other.

The nanoposts NP having the largest size among the nanoposts NP of the fourth pixel-corresponding region 134 are indicated by a4, and may be provided at positions aligned with the center of the four fourth pixels 41, 42, 43, and 44 facing each other.

The nanoposts NP having the largest size among the nanoposts NP of the second pixel-corresponding region 132 are indicated by a2, and may be provided at positions aligned with the center of the four second pixels 21, 22, 23, and 24 facing each other.

The nanopost NP having the largest size among the nanoposts NP of the third pixel-corresponding region 133 are indicated by a3, and may be provided at a position aligned with the center of the four third pixel groups 113 facing each other. The size of the nanopost a3 may be larger than that of each of the nanopost a1, the nanopost a2, and the nanopost a4.

A first period k1, a second period k2, a third period k3, and a fourth period k4 respectively indicated in the first pixel-corresponding region 131, the second pixel-corresponding region 132, the third pixel-corresponding region 133, and the fourth pixel-corresponding region 134 are defined as distances between centers of the closest nanoposts NP in the first direction (X direction) in each region. However, the disclosure is not limited thereto, and as such, similarly periods k1 to k4 may define distances between centers of the closest nanoposts NP in the second direction (Y direction) in each region.

The nanoposts NP of the second pixel-corresponding region 132 and the third pixel-corresponding region 133 may be periodically arranged in the second period k2 and the third period k3, respectively.

The first period k1 and the second period k2 may be different from each other. The first period k1 may be equal to or less than the second period k2. The first period k1 and the fourth period k4 may be the same. The second period k2 and the third period k3 may be the same.

The number of nanoposts NP of the first pixel-corresponding region 131 may be greater than the number of nanoposts NP of the second pixel-corresponding region 132 and the third pixel-corresponding region 133.

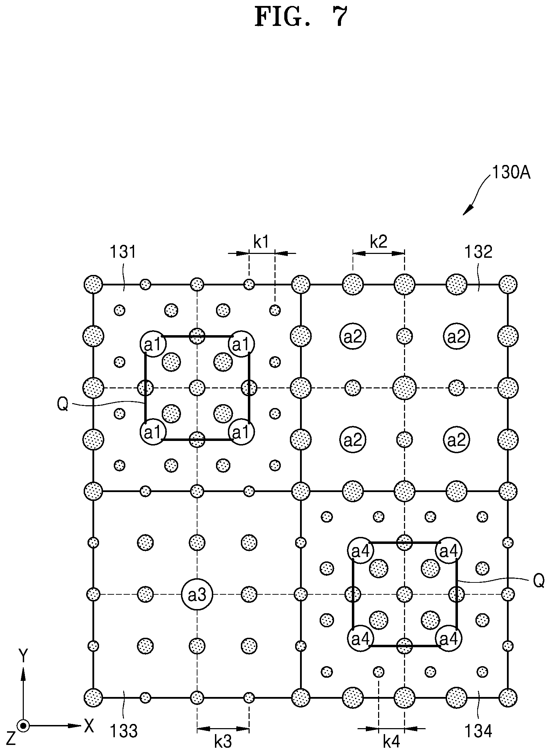

FIG. 7 is a plan view illustrating a nanopost arrangement form of a nano-optical lens array 130A provided in the pixel array 1100 of the image sensor 1000 according to another embodiment.

The nano-optical lens array 130A is different from the nano-optical lens array 130 of FIG. 6 at the positions of the nanopost a1 and the nanopost a4.

For example, the nanoposts a1 having the largest size among the nanoposts NP of the first pixel-corresponding region 131 are not aligned with the center of the four first pixels 11, 12, 13, and 14 facing each other, but are shifted in a direction toward the center of the first pixel-corresponding region 131.

Similarly, the nanoposts a4 having the largest size among the nanoposts NP of the fourth pixel-corresponding region 134 are not aligned with the center of the four fourth pixels 41, 42, 43, and 44 facing each other, but are shifted in a direction toward the center of the fourth pixel-corresponding region 134.

A shifted distance may be adjusted in detail in consideration of a focal length with respect to green light. For example, in order to adjust the focal length with respect to the green light in the nano-optical lens array 130 in the arrangement of the nanoposts NP as shown in FIG. 6, the positions of the nano-posts a1 and a4 may be adjusted in detail. For example, the positions of the nanoposts a1 and a4 may be adjusted in detail such that the focal length of the nano-optical lens array 130A with respect to the green light is as equal as possible to the focal length of the nano-optical lens array 130A with respect to the blue light and the focal length of the nano-optical lens array 130A with respect to the the red light.

The arrangement of the nanoposts NP shown in FIGS. 6 and 7 is presented as an example of implementing almost the same focal length as possible with respect to a condensing pattern for each color and light of different wavelengths as described with reference to FIG. 4, but is not limited thereto, and various modifications are possible.

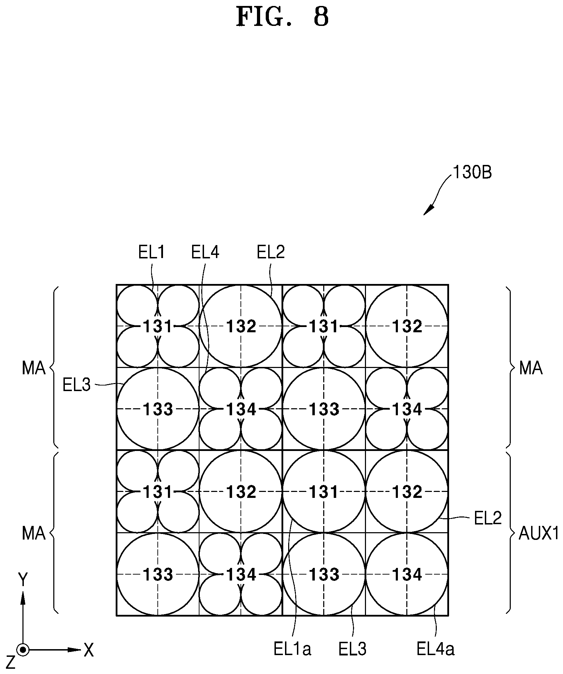

FIG. 8 is a plan view illustrating a conceptual structure of a nano-optical lens array 130B provided in the pixel array 1100 of the image sensor 1000 according to another embodiment.

The nano-optical lens array 130B illustrated in FIG. 8 is different from the above-described nano-optical lens array 130 in that the nano-optical lens array 130B further includes an auxiliary structure region AUX1.

The nano-optical lens array 130B includes a main structure region MA and the auxiliary structure region AUX1. In the main structure region MA, the first pixel-corresponding region 131 and the fourth pixel-corresponding region 134 are configured to multi-focus green light, the second pixel-corresponding region 132 is configured to single-focus blue light, and the third pixel-corresponding region 133 is configured to single-focus red light as described with reference to FIG. 4. In the auxiliary structure region AUX1, the first pixel-corresponding region 131, the second pixel-corresponding region 132, the third pixel-corresponding region 133, and the fourth pixel-corresponding region 134 are configured to single-focus the green light, the blue light, the red light, and the green light, respectively. That is, nanoposts of the auxiliary structure region AUX1 are arranged such that among light incident on one auxiliary structure region AUX1, part of the green light is single-focused on the first pixel group 111, the remaining part of the green light is single-focused on the first pixel group 114, the blue light is single-focused on the second pixel group 112, and the red light is single-focused on the third pixel group 113.

In the above-described example, in which only the main structure regions MA are included in the nano-optical lens array 130, the auxiliary structure region AUX1 is presented to compensate for the fact that a green pixel is not used as an auto-focus pixel.

FIG. 8 show three main structure regions MA and one auxiliary structure region AUX1, but this is an example. A plurality of main structure regions MA and another plurality of r auxiliary structure regions AUX1 may be included, and the number of main structure regions MA and the number of auxiliary structure regions AUX1 may be different from each other. The number of main structure regions MA may be greater than the number of auxiliary structure regions AUX1, and the number of auxiliary structure regions AUX1 may be 30 % or less, 20 % or less, or 10 % or less of the total. However, the disclosure is not limited thereto.

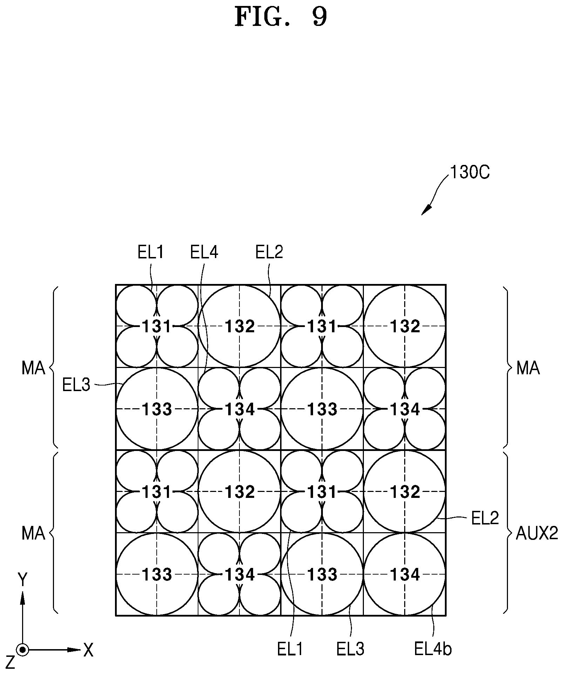

FIG. 9 is a plan view illustrating a conceptual structure of the nano-optical lens array 130C provided in the pixel array 1100 of the image sensor 1000 according to another embodiment.

The nano-optical lens array 130C illustrated in FIG. 9 is different from the above-described nano-optical lens array 130 in that the nano-optical lens array 130C further includes an auxiliary structure region AUX2.

The nano-optical lens array 130C includes the main structure region MA and the auxiliary structure region AUX2. In the main structure region MA, the first pixel-corresponding region 131 and the fourth pixel-corresponding region 134 are configured to multi-focus green light, the second pixel-corresponding region 132 is configured to single-focus blue light, and the third pixel-corresponding region 133 is configured to single-focus red light as described with reference to FIG. 4. In the auxiliary structure region AUX2, the second pixel-corresponding region 132, the third pixel-corresponding region 133, and the fourth pixel-corresponding region 134 are configured to single-focus the blue light, the red light, and the green light, respectively, and the first pixel-corresponding region 131 is configured to multi-focus the green light. That is, nanoposts of the auxiliary structure region AUX2 are arranged such that among light incident on one auxiliary structure region AUX2, part of the green light is multi-focused on the first pixel group 111, the remaining part of the green light is single-focused on the first pixel group 114, the blue light is single-focused on the second pixel group 112, and the red light is single-focused on the third pixel group 113.

In the embodiment, similar to the embodiment of FIG. 8, in an example case in which only the main structure regions MA are included in the nano-optical lens array 130, the auxiliary structure region AUX2 is presented to compensate for the fact that a green pixel is not used as an auto-focus pixel. Unlike the embodiment of FIG. 8, the auxiliary structure region AUX2 is presented as a structure in which four green pixels included in one of two green pixel groups may be used as auto-focus pixels.

FIG. 9 show three main structure regions MA and one auxiliary structure region AUX2, but this is an example. A plurality of main structure regions MA and another plurality of other auxiliary structure regions AUX2 may be included, and the number of main structure regions MA and the number of auxiliary structure regions AUX2 may be different from each other. The number of main structure regions MA may be greater than the number of auxiliary structure regions AUX2, and the number of auxiliary structure regions AUX2 may be 30 % or less, 20 % or less, or 10 % or less of the total. However, the disclosure is not limited thereto.

The nano-optical lens array of another embodiment may include a structure in which the nano-optical lens array 130B of FIG. 8 and a nano-optical lens array 130C of FIG. 9 are mixed together. For example, the nano-optical lens array according to another embodiment may include the nano-optical lens array 130 as shown in FIG. 4 as the main structure region, the auxiliary structure region AUX1 shown in FIG. 8 and the auxiliary structure region AUX2 shown in FIG. 9.

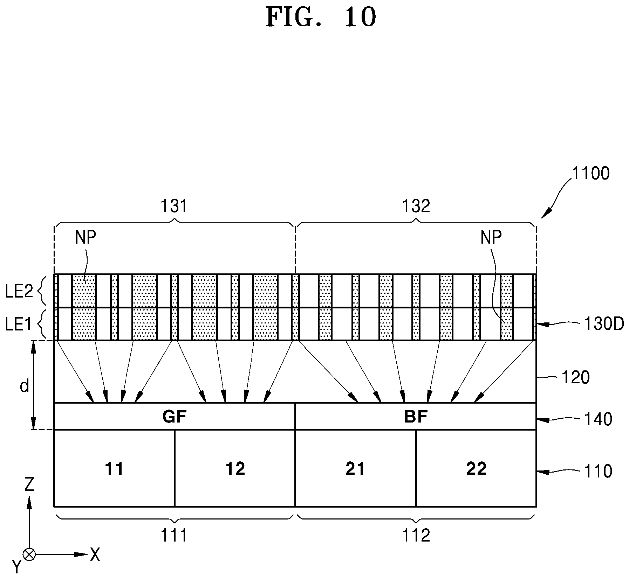

FIG. 10 is a cross-sectional view illustrating the pixel array 1100 of the image sensor 1000 according to another embodiment.

The nano-optical lens array 130D provided in the pixel array 1100 of the image sensor 1000 of the embodiment is different from the nano-optical lens array 130 described above in that the nanoposts NP are divided and arranged in two layers. For example, the nanoposts NP of the nano-optical lens array 130 are arranged separately in the first lens layer LE1 and the second lens layer LE2.

According to an embodiment, an etch stop layer may be provided between the first lens layer LE1 and the second lens layer LE2. The etch stop layer may be provided to prevent damage to the first lens layer LE1 during a process of manufacturing the second lens layer LE2. In an example case in which the second lens layer LE2 is formed on the first lens layer LE1, a process of generally depositing a dielectric layer to be formed as the peripheral material between the nanoposts NP on the first lens layer LE1, and etching the dielectric layer to a certain depth is performed. At this time, the first lens layer LE1 may be damaged due to etching of the dielectric layer to a desired depth or greater, and in an example case in which the height of the first lens layer LE1 does not meet a desired height requirement, color separation performance may deteriorate. The etch stop layer formed on the first lens layer LE1 includes a material with a lower etch selectivity than the dielectric layer to be etched, and thus may not be completely removed and partially remain during the etching process, thereby preventing damage to the first lens layer LE1. The etch stop layer may include $HfO_2$. A thickness of the etch stop layer may be determined by considering an etch depth, that is, the height of the second lens layer LE2, and may also be determined by considering an etch distribution within a process wafer. The etch stop layer may have a thickness of about 3nm to about 30nm.

The nanoposts NP of the first lens layer LE1 and the second lens layer LE2 are all shown as having the same arrangement, but this is an example, and the disclosure is not limited thereto. The aspect ratio of the nanopost NP may be substantially increased by arranging the nanoposts NP in two layers, and the degree of freedom of design with respect to the nano-optical lens array 130D may be increased such that the desired condensing characteristics may be well implemented.

The image sensor 1000 according to an embodiment may constitute a camera module together with module lenses having various performances, and may be used in various electronic devices.

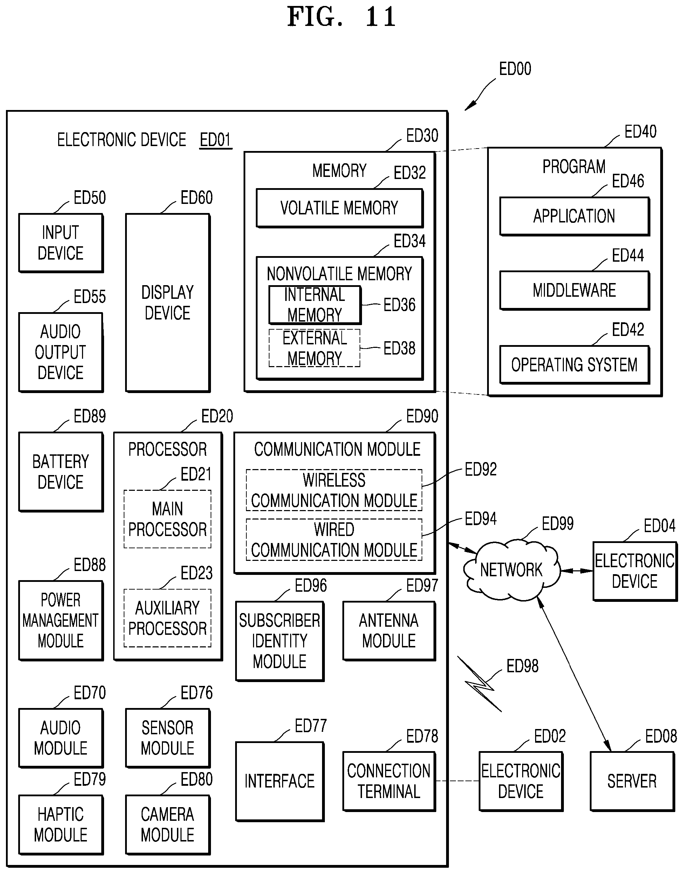

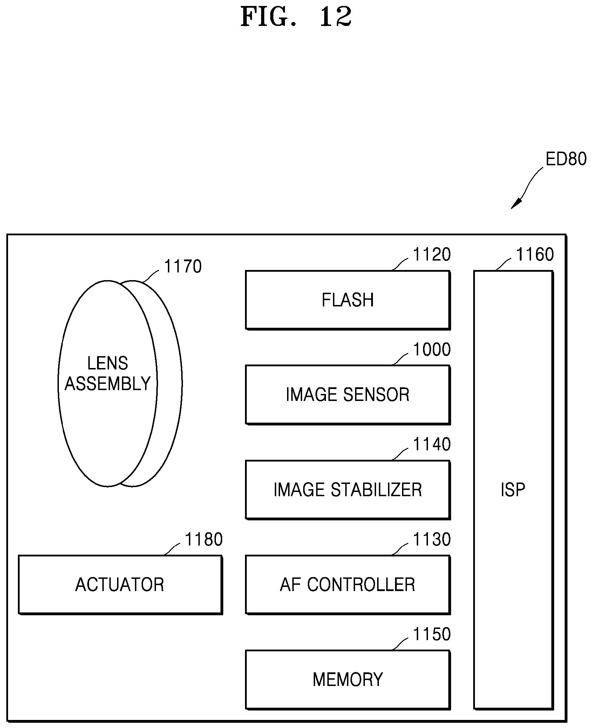

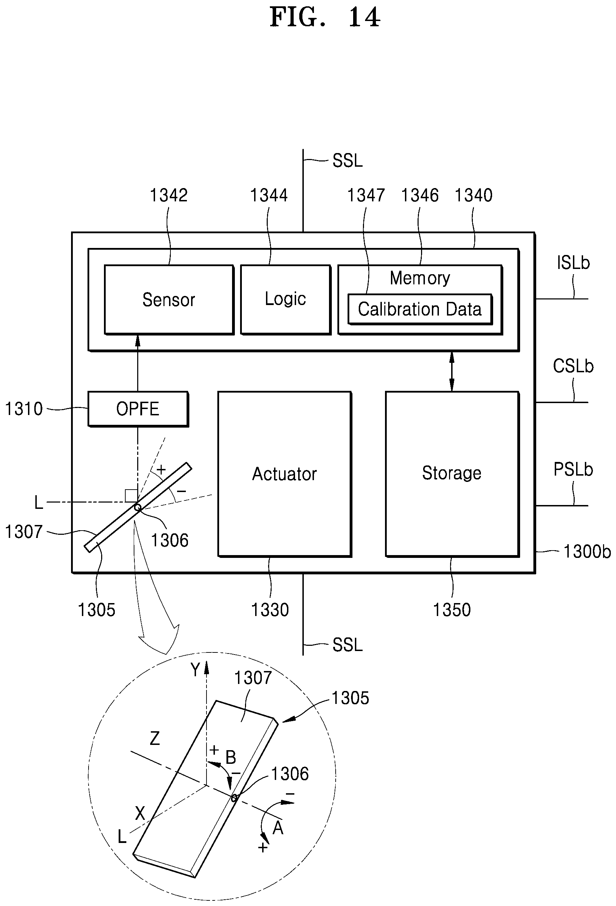

FIG. 11 is a block diagram of an example of an electronic device ED01 including the image sensor 1000. FIG. 12 is a block diagram of a camera module ED80 included in the electronic device ED01 of FIG. 14.

Referring to FIG. 11, in a network environment ED00, the electronic device ED01 may communicate with another electronic device ED02 through a first network ED98 (short-range wireless communication network, and the like), or communicate with another electronic device ED04 and/or a server ED08 through a second network ED99 (long-range wireless communication network, etc.) The electronic device ED01 may communicate with the electronic device ED04 via the server ED08. The electronic device ED01 may include a processor ED20, a memory ED30, an input device ED50, an audio output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic device ED01, some (display device ED60, etc.) of the aforementioned components may be omitted or other components may be added. Some of the components may be implemented by one integrated circuit. For example, the sensor module ED76 (a fingerprint sensor, an iris sensor, an illuminance sensor, and the like) may be implemented by being embedded in the display device ED60 (a display, etc.)

The processor ED20 may control one or a plurality of other components (hardware and software components, and the like) of the electronic device ED01 connected to the processor ED20 by executing software (a program ED40, etc.), and perform various data processing or calculations. As part of the data processing or calculations, the processor ED20 may load, in a volatile memory ED32, commands and/or data received from other components (the sensor module ED76, the communication module ED90, etc.), process the command and/or data stored in a volatile memory ED32, and store result data in a non-volatile memory ED34. The processor ED20 may include a main processor ED21 (a central processing unit, an application processor, etc.) and an auxiliary processor ED23 (a graphics processing unit, an image signal processor, a sensor hub processor, a communication processor, etc.) that is operable independently of or together with the main processor ED21. The auxiliary processor ED23 may use less power than the main processor ED21 and may perform a specialized function.

Instead of the main processor ED21 when the main processor ED21 is in an inactive state (sleep state), or with the main processor ED21 when the main processor ED21 is in an active state (application execution state), the auxiliary processor ED23 may control functions and/or states related to some components (display device ED60, the sensor module ED76, the communication module ED90, etc.) of the components of the electronic device ED01. The auxiliary processor ED23 (an image signal processor, a communication processor, etc.) may be implemented as a part of functionally related other components (the camera module ED80, the communication module ED90, etc.)

The memory ED30 may store various data needed by the components (the processor ED20, the sensor module ED76, and the like) of the electronic device ED01. The data may include, for example, software (program ED40, etc.) and input data and/or output data about commands related thereto. The memory ED30 may include the volatile memory ED32 and/or the non-volatile memory ED34.

The program ED40 may be stored in the memory ED30 as software, and may include an operating system ED42, middleware ED44, and/or an application ED46.

The input device ED50 may receive commands and/or data to be used for components (processor ED20, etc.) of the electronic device ED01, from the outside (a user, etc.) of the electronic device ED01. The input device ED50 may include a microphone, a mouse, a keyboard, and/or a digital pen (a stylus pen, etc.)

The audio output device ED55 may output an audio signal to the outside of the electronic device ED01. The audio output device ED55 may include a speaker and/or a receiver. The speaker may be used for general purposes such as multimedia playback or recording playback, and the receiver may be used to receive incoming calls. The receiver may be implemented by being coupled as a part of the speaker or by an independent separate device.

The display device ED60 may visually provide information to the outside of the electronic device ED01. The display device ED60 may include a display, a hologram device, or a projector, and a control circuit to control a corresponding device. The display device ED60 may include a touch circuitry set to detect a touch and/or a sensor circuit (a pressure sensor, etc.) set to measure the strength of a force generated by the touch.

The audio module ED70 may convert sound into electrical signals or reversely electrical signals into sound. The audio module ED70 may obtain sound through the input device ED50, or output sound through a speaker and/or a headphone of another electronic device (electronic device ED02, etc.) connected to the audio output device ED55 and/or the electronic device ED01 in a wired or wireless manner.

The sensor module ED76 may detect an operation state (power, temperature, etc.) of the electronic device ED01, or an external environment state (a user state, etc.), and generate an electrical signal and/or a data value corresponding to a detected state. The sensor module ED76 may include a gesture sensor, a gyro sensor, a barometric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface ED77 may support one or a plurality of specified protocols used for the electronic device ED01 to be connected to another electronic device (electronic device ED02, etc.) in a wired or wireless manner. The interface ED77 may include a high definition multimedia interface (HDMI), a universal serial bus (USB) interface, an SD card interface, and/or an audio interface.

A connection terminal ED78 may include a connector for the electronic device ED01 to be physically connected to another electronic device (electronic device ED02, etc.). The connection terminal ED78 may include an HDMI connector, a USB connector, an SD card connector, and/or an audio connector (a headphone connector, etc.)

The haptic module ED79 may convert electrical signals into mechanical stimuli (vibrations, movements, etc.) or electrical stimuli that are perceivable by a user through tactile or motor sensations. The haptic module ED79 may include a motor, a piezoelectric device, and/or an electrical stimulation device.

The camera module ED80 may capture a still image and a video. The camera module ED80 may include a lens assembly including one or a plurality of lenses, the image sensor 1000 of FIG. 1, image signal processors, and/or flashes. The lens assembly included in the camera module ED80 may condense light emitted from a subject for image capturing.

The power management module ED88 may manage power supplied to the electronic device ED01. The power management module ED88 may be implemented as a part of a power management integrated circuit (PMIC).

The battery ED89 may supply power to the components of the electronic device ED01. The battery ED89 may include non-rechargeable primary cells, rechargeable secondary cells, and/or fuel cells.

The communication module ED90 may establish a wired communication channel and/or a wireless communication channel between the electronic device ED01 and another electronic device (the electronic device ED02, the electronic device ED04, the server ED08, etc.), and support a communication through an established communication channel. The communication module ED90 may be operated independently of the processor ED20 (the application processor, etc.), and may include one or a plurality of communication processors supporting a wired communication and/or a wireless communication. The communication module ED90 may include a wireless communication module ED92 (a cellular communication module, a short-range wireless communication module, a global navigation satellite system (GNSS) communication module, etc.), and/or a wired communication module ED94 (a local area network (LAN) communication module, a power line communication module, etc.) Among the above communication modules, a corresponding communication module may communicate with another electronic device through the first network ED98 (a short-range communication network such as Bluetooth, WiFi Direct, or infrared data association (IrDA)) or the second network ED99 (a long-range communication network such as a cellular network, the Internet, or a computer network (LAN, WAN, etc.)) These various types of communication modules may be integrated into one component (a single chip, etc.), or may be implemented as a plurality of separate components (multiple chips). The wireless communication module ED92 may verify and authenticate the electronic device ED01 in a communication network such as the first network ED98 and/or the second network ED99 by using subscriber information (an international mobile subscriber identifier (IMSI), etc.) stored in the subscriber identification module ED96.

The antenna module ED97 may transmit signals and/or power to the outside (another electronic device, etc.) or receive signals and/or power from the outside. An antenna may include an emitter formed in a conductive pattern on a substrate (a printed circuit board (PCB), etc.) The antenna module ED97 may include one or a plurality of antennas. In an example case in which the antenna module ED97 includes a plurality of antennas, the communication module ED90 may select, from among the antennas, an appropriate antenna for a communication method used in a communication network such as the first network ED98 and/or the second network ED99. Signals and/or power may be transmitted or received between the communication module ED90 and another electronic device through the selected antenna. Other parts (an RFIC, etc.) than the antenna may be included as a part of the antenna module ED97.

Some of the components may be connected to each other through a communication method between peripheral devices (a bus, general purpose input and output (GPIO), a serial peripheral interface (SPI), a mobile industry processor interface (MIPI), etc.) and may mutually exchange signals (commands, data, etc.)

The command or data may be transmitted or received between the electronic device ED01 and the external electronic device ED04 through the server ED08 connected to the second network ED99. The electronic devices ED02 and ED04 may be of a type that is the same as or different from the electronic device ED01. All or a part of operations executed in the electronic device ED01 may be executed in one or the plurality of electronic devices ED02, ED04, and ED08. In an example case in which the electronic device ED01 is to perform a function or service, the electronic device ED01 may request one or a plurality of electronic devices to perform part or the whole of the function or service, instead of directly performing the function or service. The one or a plurality of electronic devices that received the request may execute an additional function or service related to the request and transmit a result of the execution to the electronic device ED01. To this end, a cloud computing technology, a distributed computing technology, or a client-server computing technology may be used.

Referring to FIG. 12, the camera module ED80 may include a lens assembly 1170, a flash 1120, an image sensor 1000, an image stabilizer 1140, an AF controller 1130, a memory 1150 (buffer memory, etc.), an actuator 1180, and/or an image signal processor (ISP) 1160

The lens assembly 1170 may condense light emitted from an object that is to be photographed for image capturing. The camera module ED80 may include a plurality of lens assemblies 1170, and in this case, the camera module ED80 may be a dual camera, a 360 degrees camera, or a spherical camera. Some of the lens assemblies 1170 may have the same lens attributes (a viewing angle, a focal length, auto-focus, F Number, optical zoom, etc.), or different lens attributes. The lens assembly 1170 may include a wide angle lens or a telescopic lens.

The actuator 1180 may drive the lens assembly 1170 For example, at least some of the optical lens and the path switching member included in the lens assembly 1170 may be moved by the actuator 1180. The optical lens may be moved along an optical axis, and, when a distance between adjacent lenses is adjusted by moving at least some of the optical lenses included in the lens assembly 1170, an optical zoom ratio may be adjusted.

The actuator 1180 may adjust the position of any one of the optical lenses included in the lens assembly 1170 so that the image sensor 1000 may be located at the focal length of the lens assembly 1170. The actuator 1180 may drive the lens assembly 1170 according to an AF driving signal transferred from the AF controller 1130.

The flash 1120 may emit light used to enhance light emitted or reflected from the subject. The flash 1120 may emit visible light or infrared-ray light. The flash 1120 may include one or a plurality of light-emitting diodes (a red-green-blue (RGB) LED, a white LED, an infrared LED, an ultraviolet LED, and the like), and/or a xenon lamp. The image sensor 1000 may be the image sensor 1000 described above with reference to FIG. 1, and may obtain an image corresponding to the subject by converting the light emitted or reflected by the subject and transferred through the lens assembly 1170 into an electrical signal

The image stabilizer 1140 may move, based on (or in response to) a movement of the camera module ED80 or the electronic device ED01 including the same, one or a plurality of lenses included in the lens assembly 1170 or the image sensor 1000 in a particular direction or may compensate for a negative effect due to the movement by controlling (adjustment of a read-out timing, etc.) the movement characteristics of the image sensor 1000. The image stabilizer 1140 may detect a movement of the camera module ED80 or the electronic device ED01 by using a gyro sensor or an acceleration sensor arranged inside or outside the camera module ED80. The image stabilizer 1140 may be implemented in an optical form.

The memory 1150 may store some or entire data of an image obtained through the image sensor 1000 for a subsequent image processing operation. In an example case in which a plurality of images are obtained at high speed, the obtained original data (Bayer-patterned data, high resolution data, etc.) is stored in the memory 1150 and only low resolution images are displayed. Then, the original data of a selected (user selection, etc.) image may be transferred to the ISP 1160. The memory 1150 may be incorporated into the memory ED30 of the electronic device ED01, or configured to be an independently operated separate memory.

The ISP 1160 may obtain an image by using electrical signals output from the image sensor 1000. For example, the ISP 1160 may directly perform some of image processes shown in FIGS. 23 to 26 in connection with the image sensor 1000. In addition, image data of a specific format may be requested from the image sensor 1000 according to a required image data format.

In addition, the ISP 1160 may perform additional image processes on the image obtained through the image sensor 1000 or the image data stored in the memory 1150. The image processes may include depth map generation, 3D modeling, panorama generation, feature point extraction, image synthesis, and/or image compensation (noise reduction, resolution adjustment, brightness adjustment, blurring, sharpening, softening, etc.) The ISP 1160 may perform control (exposure time control, read-out timing control, etc.) on components (image sensor 1000, etc.) included in the camera module ED80.

The image processed by the ISP 1160 may be stored again in the memory 1150 for additional processing or provided to external components (e.g., the memory ED30, the display device ED60, the electronic device ED02, the electronic device ED04, the server ED08, etc.) of the camera module ED80. The ISP 1160 may be incorporated into the processor ED20, or configured to be a separate processor operated independently of the processor ED20. In an example case in which the ISP 1160 is configured by a separate processor from the processor ED20, the image processed by the ISP 1160 may undergo additional image processing by the processor ED20 and then displayed through the display device ED6.

In addition, the ISP 1160 may independently receive two output signals from adjacent photosensitive cells within each pixel or sub-pixel of the image sensor 1000 and generate an auto-focus signal from a difference between the two output signals. The ISP 1160 may control the lens assembly 1110 such that the focus of the lens assembly 1110 is accurately aligned with a surface of the image sensor 1000 based on the auto-focus signal.

The electronic device ED01 may include one or a plurality of camera modules having different attributes or functions. The camera module may include components similar to those of the camera module ED80 of FIG. 28, and the image sensor included in the camera module may be implemented as a charge coupled device (CCD) sensor and/or a complementary metal oxide semiconductor (CMOS) sensor and may include one or a plurality of sensors selected from the image sensors having different properties, such as an RGB sensor, a black and white (BW) sensor, an IR sensor, or a UV sensor. In this case, one of the plurality of camera modules ED80 may be a wide angle camera, and another may be a telescopic camera. Similarly, one of the plurality of camera modules ED80 may be a front side camera, and another may be a rear side camera.

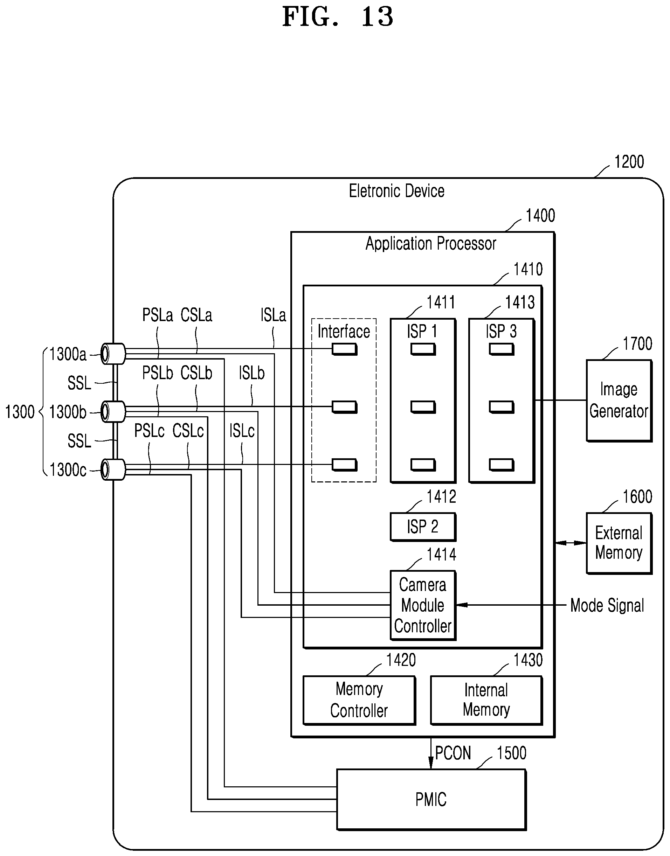

FIG. 13 is a block diagram of an electronic device 1200 including a multi-camera module, and FIG. 14 is a detailed block diagram of one camera module of the electronic device 1200 shown in FIG. 13.

Referring to FIG. 13, the electronic device 1200 may include a camera module group 1300, an application processor 1400, a power management integrated circuit (PMIC) 1500, an external memory 1600, and an image generator 1700.

The camera module group 1300 may include a plurality of camera modules 1300a, 1300b, and 1300c. The figures show an embodiment in which three camera modules 1300a, 1300b, and 1300c are arranged, but the embodiments are not limited thereto. In some embodiments, the camera module group 1300 may be modified to include only two camera modules. In addition, in some embodiments, the camera module group 1300 may be modified to include n camera modules (n is a natural number of 4 or more).

Hereinafter, the detailed configuration of the camera module 1300b is described in more detail with reference to FIG. 14, but the following description may be equally applied to the other camera modules 1300a and 1300c according to the embodiment.

Referring to FIG. 14, the camera module 1300b may include a prism 1305, an optical path folding element (hereinafter referred to as "OPFE") 1310, an actuator 1330, an image sensing device 1340, and a storage 1350.

The prism 1305 may include a reflective surface 1307 of a light reflecting material to change a path of light L incident from the outside.

In some embodiments, the prism 1305 may change the path of light L incident in the first direction X to the second direction Y perpendicular to the first direction X. In addition, the prism 1305 may rotate the reflective surface 1307 of the light reflecting material in a direction A with respect to a central axis 1306, or rotate the central axis 1306 in a direction B to change the path of light L incident in the first direction X to the second direction Y perpendicular to the first direction X. At this time, the OPFE 1310 may also move in the third direction Z perpendicular to the first direction X and the second direction Y.

In some embodiments, as shown, the maximum rotation angle of the prism 1305 in the direction A may be 15 degrees or less in a direction plus (+) A and greater than 15 degrees in a direction minus (-) A, but the embodiments are not limited thereto.

In some embodiments, the prism 1305 may move about 20 degrees, between about 10 degrees and about 20 degrees, or between about 15 degrees and about 20 degrees in a direction plus (+) B or minus (-) B, where the moving angle may be the same in the direction plus (+) B or minus (-) B, or almost similar within a range of about 1 degree.

In some embodiments, the prism 1305 may move the reflective surface 1307 of the light reflecting material in the third direction (e.g., Z) parallel to a direction of extension of the central axis 1306.

The OPFE 1310 may include, for example, an optical lens including m groups (where m is a natural number). The m lenses may by moving in the second direction Y to change an optical zoom ratio of the camera module 1300b. For example, assuming that a basic optical zoom ratio of the camera module 1300b is Z, when moving the m optical lenses included in the OPFE 1310, the optical zoom ratio of the camera module 1300b may be change to 3Z or 5Z or 10Z or higher.

The actuator 1330 may move the OPFE 1310 or an optical lens to a specific position. For example, the actuator 1330 may adjust a position of the optical lens so that the image sensor 1342 is positioned at a focal length of the optical lens for accurate sensing.

The image sensing device 1340 may include an image sensor 1342, control logic 1344, and memory 1346. The image sensor 1342 may sense an image of a sensing object by using the light L provided through the optical lens. The control logic 1344 may control the overall operation of the camera module 1300b. For example, the control logic 1344 may control the operation of the camera module 1300b according to a control signal provided through a control signal line CSLb.

The memory 1346 may store information necessary for the operation of the camera module 1300b, such as calibration data 1347. The calibration data 1347 may include information necessary to generate image data by using the light L provided from the outside through the camera module 1300b. The calibration data 1347 may include, for example, information about a degree of rotation, information about the focal length, and information about the optical axis described above. In an example case in which the camera module 1300b is implemented as a multi-state camera of which focal length changes according to the position of the optical lens, the calibration data 1347 may include a focal length value of the optical lens for each position (or state) and information related to auto-focusing.

The storage 1350 may store image data sensed through the image sensor 1342. The storage 1350 may be provided outside the image sensing device 1340 and may be implemented in the form of stacked with a sensor chip constituting the image sensing device 1340. In some embodiments, the storage 1350 may be implemented as an Electrically Erasable Programmable Read-Only Memory (EEPROM), but the embodiments are not limited thereto.

Referring to FIGS. 13 and 14 together, in some embodiments, each of the plurality of camera modules 1300a, 1300b, and 1300c may include an actuator 1330. Accordingly, each of the plurality of camera modules 1300a, 1300b, and 1300c may include the same or different calibration data 1347 according to the operation of the actuator 1330 included therein.

In some embodiments, one camera module (e.g., 1300b) of the plurality of camera modules 1300a, 1300b, and 1300c may be a folded lens type camera module including the prism 1305 and OPFE 1310 described above, and the remaining camera modules (e.g., 1300a and 1300b) may be vertical type camera modules that do not include the prism 1305 and OPFE 1310, but embodiments are not limited thereto.

In some embodiments, one camera module (e.g., 1300c) of the plurality of camera modules 1300a, 1300b, and 1300c may be a vertical type camera module that extracts depth information by using, for example, infrared ray (IR).

In some embodiments, at least two camera modules (e.g., 1300a and 1300b) among the plurality of camera modules 1300a, 1300b, and 1300c may have different fields of view. In this case, for example, optical lenses of at least two camera modules (e.g., 1300a and 1300b) among the plurality of camera modules 1300a, 1300b, and 1300c may be different from each other, but are not limited thereto.

In addition, in some embodiments, the plurality of camera modules 1300a, 1300b, and 1300c may have different fields of view. In this case, the optical lenses respectively included in the plurality of camera modules 1300a, 1300b, and 1300c may also be different from each other, but are not limited thereto.

In some embodiments, the plurality of camera modules 1300a, 1300b, and 1300c may be provided to be physically separated from each other. That is, the plurality of camera modules 1300a, 1300b, and 1300c do not divide and use a sensing area of one image sensor 1342 but an independent sensor 1342 may be provided inside each of the plurality of camera modules 1300a, 1300b, and 1300c.

Referring again to FIG. 14, the application processor 1400 may include an image processing device 1410, a memory controller 1420, and an internal memory 1430. The application processor 1400 may be implemented separately from the plurality of camera modules 1300a, 1300b, and 1300c. For example, the application processor 1400 and the plurality of camera modules 1300a, 1300b, and 1300c may be implemented separately as separate semiconductor chips.

The image processing device 1410 may include a plurality of image signal processors ISP1, ISP2, and ISP3 1411, 1412, and 1413, and a camera module controller 1414.

Image data respectively generated from the camera modules 1300a, 1300b, and 1300c may be provided to the image processing device 1410 through separate image signal lines ISLa, ISLb, and ISLc. Such image data transmission may be performed by using, for example, a Camera Serial Interface (CSI) based on Mobile Industry Processor Interface (MIPI), but the embodiments are not limited thereto.

The image data transmitted to the image processing device 1410 may be stored in the external memory 1600 before being transmitted to the image signal processors ISP1 and ISP2 1411 and 1412. Image data stored in the external memory 1600 may be provided to the image signal processor 1411 and/or the image signal processor ISP2 1412. The IPS1 1411 may correct the received image data to generate a video. The ISP2 1412 may correct the received image data to generate a still image. For example, the ISP1 1411 and ISP2 1412 may perform preprocessing operations such as color correction and gamma correction on the image data.

The ISP1 1411 may include sub processors. In an example case in which the number of sub processors is equal to the number of camera modules 1300a, 1300b, and 1300c, each of the sub processors may process image data provided from one camera module. In an example case in which the number of sub processors is less than the number of camera modules 1300a, 1300b, and 1300c, at least one of the sub processors may process image data provided from a plurality of camera modules by using a timing sharing process. The image data processed by the ISP1 1411 and/or the ISP2 1412 may be stored in the external memory 1600 before being transferred to the image processor 1413. The image data stored in the external memory 1600 may be transmitted to the ISP2 1412. The ISP2 1412 may perform post-processing operations such as noise correction and sharpening correction on the image data.

The image data processed by the ISP3 1413 may be provided to the image generator 1700. The image generator 1700 may generate a final image by using the image data provided from the image processor 1413 according to image generating information or a mode signal.

Specifically, the image generator 1700 may merge at least part of the image data generated from the camera modules 1300a, 1300b, and 1300c with different fields of view according to the image generating information or the mode signal to generate an output image. In addition, the image generator 1700 may select one of the image data generated from the camera modules 1300a, 1300b, and 1300c with different fields of view according to the image generating information or the mode signal to generate an output image.

In some embodiments, the image generating information may include a zoom signal or zoom factor. In addition, in some embodiments, the mode signal may be a signal, for example, based on a mode selected by a user.

In an example case in which the image generating information is a zoom signal (zoom factor) and the camera modules 1300a, 1300b, and 1300c have different observation fields (fields of views), the image generator 1700 may perform different operations according to the type of the zoom signal. In an example case in which the zoom signal is a first signal, the image generator 1700 may merge the image data output from the camera module 1300a and the image data output from the camera module 1300c, and then generate an output image by using a merged image signal and the image data output from the camera module 1300b that is not used for merging. In an example case in which the zoom signal is a second signal different from the first signal, the image generator 1700 may not merge the image data but may select one of the image data output from the camera modules 1300a, 1300b, and 1300c and generate an output image. However, the embodiments are not limited thereto, and the method of processing image data may be modified and implemented as necessary.

The camera module controller 1414 may respectively provide control signals to the camera modules 1300a, 1300b, and 1300c. The control signals generated from the camera module controller 1414 may be respectively provided to the corresponding camera modules 1300a, 1300b, and 1300c through separate control signal lines CSLa, CSLb, and CSLc.

In some embodiments, the control signals provided from the camera module controller 1414 to the plurality of camera modules 1300a, 1300b, and 1300c may include mode information according to the mode signal. Based on the mode information, the plurality of camera modules 1300a, 1300b, and 1300c may operate in a first operation mode and a second operation mode in relation to a sensing speed.

In the first operation mode, the plurality of camera modules 1300a, 1300b, and 1300c may generate an image signal at a first speed (e.g., generate an image signal at a first frame rate) and encode the image signal to a second speed higher than the first speed (e.g., encode an image signal of a second frame rate higher than the first frame rate), and transmit the encoded image signal to the application processor 1400. At this time, the second speed may be 30 times or less than the first speed.

The application processor 1400 may store the received image signal, that is, the encoded image signal, in the memory 1430 provided inside or the storage 1600 outside the application processor 1400, and then read and decode the encoded image signal from the memory 1430 or the storage 1600, and display image data generated based on the decoded image signal. For example, the image signal processors ISP1 and ISP2) 1411 and 1412 of the image processing device 1410 may perform decoding and may also perform image processing on the decoded image signal.

In the second operation mode, the plurality of camera modules 1300a, 1300b, and 1300c may generate image signals at a third speed lower than the first speed (e.g., generate image signals at a third frame rate lower than the first frame rate) and transmit the image signals to the application processor 1400. The image signals provided to the application processor 1400 may be signals that are not encoded. The application processor 1400 may perform image processing on the received image signals or store the image signals in the memory 1430 or the storage 1600.

The PMIC 1500 may supply power, for example, a power supply voltage, to each of the plurality of camera modules 1300a, 1300b, and 1300c. For example, the PMIC 1500, under the control of the application processor 1400, may supply first power to the camera module 1300a through a power signal line PSLa, supply second power to the camera module 1300b through a power signal line PSLb, and supply third power to the camera module 1300c through a power signal line PSLc.

The PMIC 1500 may generate power corresponding to each of the plurality of camera modules 1300a, 1300b, and 1300c based on (or in response) to a power control signal PCON from the application processor 1400, and may also adjust a power level. The power control signal PCON may include a power adjustment signal for each operation mode of the plurality of camera modules 1300a, 1300b, and 1300c. For example, the operation mode may include a low power mode, and in this regard, the power control signal PCON may include information about a camera module operating in the low power mode and the set power level. Levels of the power provided to the plurality of camera modules 1300a, 1300b, and 1300c may be the same as or different from each other. In addition, the level of power may dynamically change.

The image sensor according to an embodiment includes a nano-optical lens array that performs both color separation and light condensing functions, and thus light utilization efficiency may be improved.

The image sensor according to an embodiment performs an auto-focus function, but resolution degradation may be minimized, by using the nano-optical lens array described above.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. An image sensor comprising:

   a sensor substrate comprising a first pixel group, a second pixel group, a third pixel group and a fourth pixel group, the first pixel group comprising a plurality of consecutively arranged first pixels, the second pixel group comprising a plurality of consecutively arranged second pixels, the third pixel group comprising a plurality of consecutively arranged third pixels, and the fourth pixel group comprising a plurality of consecutively arranged fourth pixels; and
   a nano-optical lens array comprising a first pixel-corresponding region facing the first pixel group, a second pixel-corresponding region facing the second pixel group, a third pixel-corresponding region facing the third pixel group, and a fourth pixel-corresponding region facing the fourth pixel group,
   wherein each of the first pixel-corresponding region, the second pixel-corresponding region, the third pixel-corresponding region, and the fourth pixel-corresponding region comprises one or more nanoposts configured to separate incident light according to wavelengths,
   wherein the nano-optical lens array is configured to multi-focus green light respectively on the plurality of consecutively arranged first pixels or the plurality of consecutively arranged fourth pixels, single-focus blue light on the second pixel group, and single-focus red light on the third pixel group.

2. The image sensor of claim 1, wherein a first focal length of the nano-optical lens array with respect to the blue light is 80 % or more and 120 % or less of a second focal length of the nano-optical lens array with respect to the green light.

3. The image sensor of claim 1 or 2, wherein the one or more nanoposts of the first pixel-corresponding region are arranged to have 4-fold symmetry within a first region comprising a center of the first pixel-corresponding region with respect to the center, and optionally wherein an area of the first region is 1/4 of an entire area of the first pixel-corresponding region.

4. The image sensor of claim 3, wherein the one or more nanoposts of the first pixel-corresponding region are arranged to have 2-fold symmetry with respect to the center of the first pixel-corresponding region.

5. The image sensor of any preceding claim, wherein a distance indicating a phase difference $\pi$ in a blue light phase profile viewed in a cross-section immediately after passing through the second pixel-corresponding region is greater than p and less than 1.25p in a case in which one width of the second pixel-corresponding region is 2p.

6. The image sensor of any preceding claim, wherein a distance indicating a phase difference $\pi$ in a red light phase profile viewed in a cross-section immediately after passing through the third pixel-corresponding region is less than 1.25p in a case in which one width of the third pixel-corresponding region is 2p.

7. The image sensor of any preceding claim, wherein a nanopost having a largest size among the one or more nanoposts of the first pixel-corresponding region are aligned with a center of the plurality of consecutively arranged first pixels facing the first pixel-corresponding region.

8. The image sensor of any preceding claim, wherein a nanoposts having a largest size among the one or more nanoposts of the first pixel-corresponding region are shifted by a first distance in a direction toward a center of the first pixel-corresponding region compared to a center of the plurality of consecutively arranged first pixels facing the first pixel-corresponding region.

9. The image sensor of any preceding claim, wherein

a first distance between centers of closest nanoposts in the first pixel-corresponding region is a first period,
a second distance between centers of closest nanoposts in the second pixel-corresponding region is a second period,
a third distance between centers of closest nanoposts in the third pixel-corresponding region is a third period, and
the first period and the second period are different from each other,
and optionally wherein at least one of:

the first period is less than the second period; and
the second period is same as the third period.

10. The image sensor of any preceding claim, wherein a nanopost having a largest size among the one or more nanoposts of the second pixel-corresponding region are aligned with a center of the plurality of consecutively arranged second pixels facing the second pixel-corresponding region.

11. The image sensor of any preceding claim, wherein a nanopost having a largest size among the one or more nanoposts of the third pixel-corresponding region is aligned with a center of the third pixel group facing the third pixel-corresponding region.

12. The image sensor of any preceding claim, wherein a nanopost having a largest size among the one or more nanoposts in the first pixel-corresponding region, the second pixel-corresponding region, the third pixel-corresponding region and the fourth pixel-corresponding region, is located in the third pixel-corresponding region.

13. The image sensor of any preceding claim, wherein a number of nanoposts in the first pixel-corresponding region is greater than a number of nanoposts in the second pixel-corresponding region.

14. The image sensor of any preceding claim, wherein the sensor substrate further comprises:

a plurality of first pixel groups, a plurality of second pixel groups, a plurality of third pixel groups, and a plurality of fourth pixel groups, and
wherein the nano-optical lens array further comprises:

an auxiliary structure region in which a plurality of nanoposts are arranged to:

separate the incident light according to the wavelengths,
single-focus part of the green light on one of the plurality of first pixel groups,
single-focus remaining part of the green light on one of the plurality of fourth pixel groups,

single-focus the blue light on one of the plurality of second pixel groups, and
single-focus the red light on one of the plurality of third pixel groups.

15. The image sensor of any preceding claim, wherein the sensor substrate further comprises:

a plurality of first pixel groups, a plurality of second pixel groups, a plurality of third pixel groups, and a plurality of fourth pixel groups, and
wherein the nano-optical lens array further comprises an auxiliary structure region in which a plurality of nanoposts are arranged to:

separate the incident light according to the wavelengths,
single-focus part of the green light on one of the plurality of first pixel groups,
multi-focus remaining part of the green light on a plurality of consecutively arranged fourth pixels of the plurality of fourth pixel groups,
single-focus the blue light on one of the plurality of second pixel groups, and
single-focus the red light on one of the plurality of third pixel groups.

# FIG. 1

1000

1100

1020 — ROW DECODER

1010 — T/C

1030

OUTPUT CIRCUIT

# FIG. 2A

# FIG. 2B

# FIG. 2C

# FIG. 2D

# FIG. 3A

# FIG. 3B

# FIG. 4

# FIG. 5A

# FIG. 5B

# FIG. 5C

# FIG. 6

# FIG. 7

# FIG. 8

# FIG. 9

# FIG. 10

# FIG. 11

ED00

**ELECTRONIC DEVICE ED01**

ED50
**INPUT DEVICE**

ED55
**AUDIO OUTPUT DEVICE**

ED60
**DISPLAY DEVICE**

ED30
**MEMORY** ED32
**VOLATILE MEMORY**

ED34
**NONVOLATILE MEMORY**
**INTERNAL MEMORY** ED36
**EXTERNAL MEMORY** ED38

ED40
**PROGRAM** ED46
**APPLICATION**

ED44
**MIDDLEWARE**

ED42
**OPERATING SYSTEM**

ED89
**BATTERY DEVICE**

ED88
**POWER MANAGEMENT MODULE**

ED20
**PROCESSOR** ED21
**MAIN PROCESSOR**

ED23
**AUXILIARY PROCESSOR**

ED90
**COMMUNICATION MODULE**
ED92
**WIRELESS COMMUNICATION MODULE**
ED94
**WIRED COMMUNICATION MODULE**

ED96
**SUBSCRIBER IDENTITY MODULE**

ED97
**ANTENNA MODULE**

ED99
**NETWORK**

ED04
**ELECTRONIC DEVICE**

ED98

ED70
**AUDIO MODULE**

ED76
**SENSOR MODULE**

ED79
**HAPTIC MODULE**

ED80
**CAMERA MODULE**

ED77
**INTERFACE**

ED78
**CONNECTION TERMINAL**

ED02
**ELECTRONIC DEVICE**

ED08
**SERVER**

# FIG. 12

ED80

1170 LENS ASSEMBLY

1120 FLASH

1000 IMAGE SENSOR

1140 IMAGE STABILIZER

1180 ACTUATOR

1130 AF CONTROLLER

1150 MEMORY

1160 ISP

# FIG. 13

# FIG. 14

Europäisches
Patentamt

European
Patent Office

Office européen
des brevets

# EUROPEAN SEARCH REPORT

**Application Number**

EP 25 19 4170

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/261019 A1 (ROH SOOKYOUNG [KR] ET AL) 17 August 2023 (2023-08-17) | 1,3-15 | INV.<br>H10F39/18 |
| Y | * paragraph [0058] - paragraph [0109]; figures 7,8,9 * | 2 | H10F39/00 |
| Y | KR 2022 0057410 A (SAMSUNG ELECTRONICS CO LTD [KR]) 9 May 2022 (2022-05-09)<br>* paragraph [0065] * | 2 | |
| A | US 2024/243148 A1 (CHO CHOONLAE [KR] ET AL) 18 July 2024 (2024-07-18)<br>* paragraph [0081] - paragraph [0148]; figures 7-17 * | 1-15 | |
| A | US 2023/170365 A1 (LEE SANGYUN [KR] ET AL) 1 June 2023 (2023-06-01)<br>* the whole document * | 1 | |

**TECHNICAL FIELDS SEARCHED (IPC)**

H10F

The present search report has been drawn up for all claims

| Place of search | Date of completion of the search | Examiner |
|---|---|---|
| The Hague | 11 December 2025 | Hedouin, Mathias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 19 4170

This annex lists the patent family members relating to the patent documents cited in the above-mentioned European search report.
The members are as contained in the European Patent Office EDP file on
The European Patent Office is in no way liable for these particulars which are merely given for the purpose of information.

11-12-2025

| Patent document cited in search report | Publication date | Patent family member(s) | Publication date |
|---|---|---|---|
| US 2023261019 A1 | 17-08-2023 | US 2021167110 A1<br>US 2023261019 A1 | 03-06-2021<br>17-08-2023 |
| KR 20220057410 A | 09-05-2022 | NONE | |
| US 2024243148 A1 | 18-07-2024 | CN 118352368 A<br>EP 4401143 A2<br>KR 20240113276 A<br>US 2024243148 A1 | 16-07-2024<br>17-07-2024<br>22-07-2024<br>18-07-2024 |
| US 2023170365 A1 | 01-06-2023 | CN 116190396 A<br>EP 4187606 A1<br>KR 20230080192 A<br>KR 20240095399 A<br>US 2023170365 A1<br>US 2024395840 A1 | 30-05-2023<br>31-05-2023<br>07-06-2023<br>25-06-2024<br>01-06-2023<br>28-11-2024 |

EPO FORM P0459

For more details about this annex : see Official Journal of the European Patent Office, No. 12/82